# EUROPÄISCHE PATENTSCHRIFT

(11) **EP 0 842 491 B1**
(45) Veröffentlichungstag und Bekanntmachung des Hinweises auf die Patenterteilung: **08.06.2005**
(21) Anmeldenummer: 96921032.7
(22) Anmeldetag: 15.07.1996
(51) Int. Cl.: G06K 19/077

(54) **DATENTRÄGER MIT EINEM EINEN BAUTEIL AUFWEISENDEN MODUL UND MIT EINER SPULE UND VERFAHREN ZUM HERSTELLEN EINES SOLCHEN DATENTRÄGERS**
DATA CARRIER WITH A COMPONENT-BEARING MODULE AND A COIL, AND A PROCESS FOR FABRICATING SUCH A DATA CARRIER
SUPPORT DE DONNEES COMPORTANT UN MODULE POURVU D'UN COMPOSANT ET D'UNE BOBINE, ET PROCEDE DE FABRICATION DUDIT SUPPORT DE DONNEES

(30) Priorität: 01.08.1995 AT 42295
(43) Veröffentlichungstag der Anmeldung: 20.05.1998
(73) Patentinhaber: Austria Card Plastikkarten und Ausweissysteme Gesellschaft MBH, 1232 Vienna (AT)
(72) Erfinder: PRANCZ, Markus, A-1200 Vienna (AT)
(74) Vertreter: Weber, Helmut
(86) Internationale Anmeldenummer: PCT/IB1996/000690
(87) Internationale Veröffentlichungsnummer: WO 1997/005569

(56) Entgegenhaltungen:
- EP-A- 0 595 549
- EP-A- 0 646 895
- EP-A- 0 671 705
- EP-A- 0 682 321
- DE-A- 4 337 921
- DE-C- 4 403 753
- FR-A- 2 659 767

## Beschreibung

Die Erfindung bezieht sich auf einen Datenträger mit einem Datenträgerkörper, der von einer Körperfläche begrenzt ist und in den ein Modul und eine gegenüber dem Modul separate, Spulenwindungen und mindestens zwei Spulenanschlusskontakte aufweisende Spule aufgenommen ist, wobei der Modul einen plattenförmigen Träger, der im wesentlichen parallel zu der besagten Körperfläche verläuft und der von einer der besagten Körperfläche zugewandten ersten Trägerhauptfläche und von einer von der besagten Körperfläche abgewandten und zu der ersten Trägerhauptfläche im wesentlichen parallelen zweiten Trägerhauptfläche begrenzt ist, und mindestens einen Bauteil, der in den Datenträgerkörper aufgenommen und mit dem Träger verbunden und gegenüber der zweiten Trägerhauptfläche erhaben ist und der in einem sich quer zu der besagten Körperfläche erstreckenden Bauteilniveaubereich liegt, und mindestens zwei Modulanschlusskontakte aufweist, die mit dem Träger verbunden und in dem Bereich der zweiten Trägerhauptfläche vorgesehen sind, und wobei die Spulenwindungen und die Spulenanschlusskontakte der Spule zumindest in ihrem zu dem Bauteil benachbarten Bereich in einem sich quer zu der besagten Körperfläche erstreckenden und außerhalb des Bauteilniveaubereichs liegenden Spulenniveaubereich liegen und wobei jeder Spulenanschlusskontakt in einer quer zu der zweiten Trägerhauptfläche verlaufenden Richtung einem Modulanschlusskontakt gegenüberliegt und mit letzterem in elektrisch leitender Verbindung steht und wobei zwischen jedem Modulanschlusskontakt und dem ihm gegenüberliegenden Spulenanschlusskontakt ein über seine gesamte Länge von dem Datenträgerkörper umgebener, an die beiden Anschlusskontakte angrenzender Kanal vorgesehen ist und wobei jeder Kanal als elektrisch leitendes Verbindungsmittel eine in einem pastösen oder flüssigen Zustand in den Kanal einbringbare elektrisch leitende Masse enthält, mit dem die elektrisch leitende Verbindung zwischen einem Modulanschlusskontakt und einem Spulenanschlusskontakt gebildet ist.

Weiters bezieht sich die Erfindung auf ein Verfahren zum Herstellen eines Datenträgers, bei dem ein Datenträgerkörper hergestellt wird, der von einer Körperfläche begrenzt ist, und bei dem beim Herstellen des Datenträgerkörpers eine Spule, die Spulenwindungen und mindestens zwei Spulenanschlusskontakte aufweist, in den Datenträgerkörper aufgenommen wird, wobei die Spulenwindungen und die Spulenanschlusskontakte zumindest in ihrem zu dem Bauteil benachbarten Bereich in einem sich quer zu der besagten Körperfläche erstreckenden und außerhalb des Bauteilniveaubereichs liegenden Spulenniveaubereich zu liegen kommen, und bei dem in den Datenträgerkörper ein Modul aufgenommen wird, der einen plattenförmigen, von einer ersten Trägerhauptfläche und von einer zu der ersten Trägerhauptfläche im wesentlichen parallelen zweiten Trägerhauptfläche begrenzten Träger und einen mit dem Träger verbundenen, gegenüber der zweiten Trägerhauptfläche erhabenen Bauteil und mindestens zwei mit dem Träger verbundene, im Bereich der zweiten Trägerhauptfläche vorgesehene Modulanschlusskontakte aufweist, wobei die erste Trägerhauptfläche der besagten Körperfläche zugewandt und die zweite Trägerhauptfläche von der besagten Körperfläche abgewandt zu liegen kommen und wobei der Bauteil in einem sich quer zu der besagten Körperfläche erstreckenden Bauteilniveaubereich zu liegen kommt, und bei dem je ein Modulanschlusskontakt und je ein Spulenanschlusskontakt in einer quer zu der zweiten Trägerhauptfläche verlaufenden Richtung einander gegenüberliegend zu liegen kommen und in elektrisch leitende Verbindung gebracht werden und bei dem in dem Datenträgerkörper quer zu der besagten Körperfläche verlaufende, über ihre gesamte Länge von dem Datenträgerkörper umgebene Kanäle hergestellt werden, von denen jeder bis zu einem Spulenanschlusskontakt reicht und von denen jeder vor dem Aufnehmen des Moduls in den Datenträgerkörper über sein von dem Spulenanschlusskontakt abgewandtes Ende von außen her zugänglich ist, und bei dem in jeden Kanal als elektrisch leitendes Verbindungsmittel eine pastöse oder flüssige elektrisch leitende Masse eingebracht wird und bei dem beim Aufnehmen des Moduls in den Datenträgerkörper jeder mit dem Träger des Moduls verbundene Modulanschlusskontakt mit der in einen Kanal eingebrachten elektrisch leitenden Masse mit einem gegenüberliegenden Spulenanschlusskontakt in elektrisch leitende Verbindung gebracht wird.

Ein solcher als Chipkarte ausgebildeter Datenträger gemäß der vorstehend im ersten Absatz angeführten Gattung und ein Verfahren gemäß der vorstehend im zweiten Absatz angeführten Gattung sind beispielsweise aus dem Dokument US 5 598 032 A = EP 0 671 705 A2 bekannt.

Bei der bekannten Chipkarte weisen die Kanäle über ihre gesamte Längserstreckung eine stets gleiche Querschnittsfläche auf, so dass die Kanäle über ihre gesamte Längserstreckung exakt zylindrisch ausgebildet sind. Beim Herstellen der bekannten Chipkarte ist in jeden Kanal eine pastöse elektrisch leitende Masse einbringbar, mit deren Hilfe die elektrisch leitende Verbindung zwischen den Modulanschlusskontakten und den Spulenanschlusskontakten hergestellt wird. Bei der bekannten Chipkarte besteht die Schwierigkeit, dass das Einbringen der pastösen Masse sehr genau dosiert werden muss, um mit Sicherheit eine elektrisch leitende Verbindung zwischen den Modulanschlusskontakten und den Spulenanschlusskontakten zu gewährleisten bzw. um ein Verschmutzen durch überschüssige pastöse Masse zu vermeiden. Wird nämlich bei der bekannten Chipkarte zu wenig pastöse Masse in die Kanäle eingebracht, dann kann dies zur Folge haben, dass überhaupt keine elektrisch leitende Verbindung zwischen der pastösen Masse und den Modulanschlusskontakten erhalten wird. Wenn hingegen zu viel pastöse Masse in die Kanäle eingebracht wird, dann hat dies beim Einsetzen des Moduls in den Datenträgerkörper zur Folge, dass die überschüssige pastöse Masse über die Modulanschlusskontakte und über den plattenförmigen Träger des Moduls verteilt wird, was zu einem unerwünschten Verschmutzen bzw. zu anderen unerwünschten Auswirkungen führen kann.

Die Erfindung hat sich zur Aufgabe gestellt, die vorstehend angeführten Probleme und Schwierigkeiten auf einfache Weise und mit einfachen Mitteln zu vermeiden und einen Datenträger entsprechend der eingangs im ersten Absatz angeführten Gattung sowie ein Verfahren entsprechend der eingangs im zweiten Absatz angeführten Gattung zu verbessern und hierdurch einen verbesserten Datenträger zu erhalten, bei dem stets eine zuverlässige elektrische Verbindung zwischen den Spulenanschlusskontakten und den mit diesen in elektrisch leitender Verbindung stehenden Modulanschlusskontakten erreicht ist und unerwünschte Verschmutzungen durch eine überschüssige pastöse Masse vermieden sind.

Zur Lösung der vorstehend angeführten Aufgabe ist bei einem Datenträger entsprechend der eingangs im ersten Absatz angeführten Gattung gemäß der Erfindung vorgesehen, dass jeder Kanal an seinen von dem an ihn angrenzenden Spulenanschlusskontakt abgewandten und dem an ihn angrenzenden Modulanschlusskontakt zugewandten Ende eine von dem Kanal seitlich weg verlaufende Tasche aufweist, in der überschüssige elektrisch leitende Masse aufnehmbar ist.

Durch die erfindungsgemäßen Maßnahmen ist auf eine äußerst einfache und preiswerte Art und Weise und praktisch ohne zusätzliche Mittel erreicht, dass beim Herstellen eines erfindungsgemäßen Datenträgers das Dosieren der in die Kanäle einzubringenden pastösen Masse relativ unkritisch ist, nämlich dahingehend, dass ohne weiteres ein geringfügiges Überdosieren der pastösen Masse vorteilhaft ist, weil auf diese Weise stets mit Sicherheit eine elektrisch leitende Verbindung zwischen den Modulanschlusskontakten und der pastösen Masse und folglich den Spulenanschlusskontakten erhalten wird. Weiters ist durch die erfindungsgemäßen Maßnahmen gewährleistet, dass ein überdosierter Anteil an pastöser Masse beim Einsetzen des Moduls in den Datenträgerkörper in die von den Kanälen seitlich abgehenden Taschen hineingedrückt wird, wodurch erreicht ist, dass es durch den überdosierten Anteil an pastöser Masse zu keiner Verschmutzung und zu keinen anderen nachteiligen Auswirkungen im Bereich der Modulanschlusskontakte bzw. des plattenförmigen Trägers des Moduls kommen kann und der in die Taschen hineingedrückte überdosierte Anteil an pastöser Masse zusätzlich zur elektrisch leitenden Verbindung zwischen den Modulanschlusskontakten und der pastösen Masse beiträgt.

Bei einem erfindungsgemäßen Datenträger, bei dem der Datenträger eine abgestufte Ausnehmung aufweist, die in die besagte Körperfläche mündet und die einen an die besagte Körperfläche angrenzenden, im Querschnitt größeren ersten Ausnehmungsbereich, der durch eine im wesentlichen parallel zu der besagten Körperfläche verlaufende ringförmige Begrenzungsfläche begrenzt ist, und einen an den ersten Ausnehmungsbereich an dessen von der besagten Körperfläche abgewandter Seite anschließenden, im Querschnitt kleineren zweiten Ausnehmungsbereich aufweist und in die der Modul eingesetzt ist, wobei der Träger des Moduls mit einem ringförmigen Abschnitt der zweiten Trägerhauptfläche der ringförmigen Begrenzungsfläche des ersten Ausnehmungsbereiches gegenüberliegt, und bei dem die Modulanschlusskontakte zumindest teilweise im Bereich des ringförmigen Abschnittes der zweiten Trägerhauptfläche vorgesehen sind und bei dem die Kanäle von der ringförmigen Begrenzungsfläche des ersten Ausnehmungsbereiches ausgehend durch den Datenträgerkörper hindurch bis zu den Spulenanschlusskontakten reichen, hat sich weiters als sehr vorteilhaft erwiesen, wenn die von den Kanälen seitlich weg verlaufenden Taschen ebenso von der ringförmigen Begrenzungsfläche des ersten Ausnehmungsbereichs ausgehen und zu dieser Begrenzungsfläche hin offen sind. Eine solche Ausbildung hat sich im Hinblick auf eine sehr preiswerte Herstellbarkeit als sehr günstig erwiesen.

Bei einem wie im vorstehenden Absatz angeführten erfindungsgemäßen Datenträger hat sich als besonders vorteilhaft erwiesen, wenn die Ausnehmung und die Kanäle und die Taschen durch einen Fräsvorgang hergestellt sind. Dies ist im Hinblick auf eine hochpräzise Herstellbarkeit der zum Aufnehmen des Moduls vorgesehenen Ausnehmung und der Kanäle zu den Spulenanschlusskontakten und den Taschen besonders vorteilhaft.

Bei einem erfindungsgemäßen Datenträger hat sich als besonders vorteilhaft erwiesen, wenn jeder Kanal als elektrisch leitende Masse, die das elektrisch leitende Verbindungsmittel bildet, ein elektrisch leitendes Klebemittel enthält. Auf diese Weise ist erreicht, dass die Verbindungsmittel nicht nur zum elektrischen Verbinden dienen, sondern zusätzlich auch noch eine gute und feste mechanische Klebeverbindung bilden, mit der über die Modulanschlusskontakte der Modul an dem Datenträgerkörper des Datenträgers festgehalten wird.

Bei einem erfindungsgemäßen Datenträger, bei dem die Spulenanschlusskontakte gemeinsam mit den Spulenwindungen der Spule in dem Windungsniveaubereich liegen, hat sich weiters als besonders vorteilhaft erwiesen, wenn die Spulenwindungen und die Spulenanschlusskontakte der Spule durch mit einem Siebdruckverfahren hergestellte Leiterbahnen gebildet sind. Auf diese Weise sind die Vorteile von Siebdruckverfahren, deren Anwendung bei der Herstellung von Spulen für Datenträger an sich bekannt ist, auch bei einem erfindungsgemäßen Datenträger vorteilhafterweise ausgenützt.

Im vorstehend angeführten Zusammenhang hat sich weiters als sehr vorteilhaft erwiesen, wenn die Spulenwindungen und die Spulenanschlusskontakte der Spule durch mit einem Siebdruckverfahren unter Verwendung einer Silberleitpaste hergestellte Leiterbahnen gebildet sind. Dies erweist sich in der Praxis als besonders günstig.

Bei einem erfindungsgemäßen Datenträger, bei dem ein einen Bauteil tragender Modul in eine in eine Körperfläche des Datenträgerkörpers mündende Ausnehmung eingesetzt ist, wobei dann die erste Trägerhauptfläche des Trägers des Moduls üblicherweise von außerhalb des Datenträgers sowohl mechanisch abtastbar als auch visuell wahrnehmbar ist, kann die erste Trägerhauptfläche des Trägers des Moduls zur Erzielung eines optischen Effektes mit einer Bedruckung versehen sein. Es kann aber auch sehr vorteilhaft sein, wenn mit dem Träger des Moduls im Bereich seiner ersten Trägerhauptfläche vorgesehene weitere Modulanschlusskontakte verbunden sind, die zum Zusammenwirken mit von außerhalb des Datenträgers mit ihnen in Kontaktverbindung bringbaren Gegenkontakten ausgebildet sind. Auf diese Weise ist erreicht, dass in einem solchen Datenträger als Bauteil ein sogenannter Doppel-Zweck-Chip zum Einsatz kommen kann, dessen im Bereich der zweiten Trägerhauptfläche vorgesehene Modulanschlusskontakte mit den Spulenanschlusskontakten einer Spule verbunden sind, die zum berührungslosen Datenaustausch zwischen dem Doppel-Zweck-Chip und einer Schreib/Lese-Station und gegebenenfalls zur berührungslosen Energieübertragung zu dem Doppel-Zweck-Chip vorgesehen ist, und dessen im Bereich der ersten Trägerhauptfläche vorgesehene weitere Modulanschlusskontakte zum kontaktbehafteten Datenaustausch zwischen dem Doppel-Zweck-Chip und einer Schreib/Lese-Station und zur kontaktbehafteten Energieübertragung zu dem Doppel-Zweck-Chip vorgesehen sind.

Erfindungsgemäße Datenträger können unterschiedlichen Zwecken dienen und verschiedene Formen aufweisen, beispielsweise eine Schlüsselform, eine Stabform und andere Formen. In diesem Zusammenhang ist noch ausdrücklich festzustellen, dass bei diesen Formen von erfindungsgemäßen Datenträgern unter der besagten Körperfläche nicht unbedingt die flächenmäßig größte Körperbegrenzungsfläche zu verstehen ist. Bei einer Stabform kann die im vorliegenden Zusammenhang die besagte Körperfläche darstellende Körperbegrenzungsfläche durch eine Stirnfläche des stabförmigen Datenträgers gebildet sein. Dies gilt ebenso für einen schlüsselförmigen Datenträger und auch andersförmige Datenträger. Eine besonders bevorzugte Variante eines erfindungsgemäßen Datenträgers ist dadurch gekennzeichnet, dass der Datenträger als Chipkarte ausgebildet ist.

Ein Verfahren gemäß der eingangs im zweiten Absatz angeführten Gattung ist gemäß der Erfindung dadurch gekennzeichnet, dass die Kanäle mit einem Materialabtragungsverfahren hergestellt werden und dass jeder Kanal an seinem von dem an ihn angrenzenden Spulenanschlusskontakt abgewandten Ende mit einem vorzugsweise mit demselben Materialabtragungsverfahren mit einer von dem Kanal seitlich weg verlaufenden Tasche versehen wird, in der überschüssiges Material aufnehmbar ist. Mit einem solchen erfindungsgemäßen Verfahren sind erfindungsgemäße Datenträger auf sehr preiswerte und zuverlässige Weise mit hoher Qualität und hoher Präzision in einer Massenproduktion herstellbar.

Bei einem erfindungsgemäßen Verfahren, bei dem in dem hergestellten Datenträgerkörper durch Materialabtragung eine abgestufte Ausnehmung hergestellt wird, die in die besagte Körperfläche mündet und die einen an die besagte Körperfläche angrenzenden, im Querschnitt größeren ersten Ausnehmungsbereich, der durch eine im wesentlichen parallel zu der besagten Körperfläche verlaufende ringförmige Begrenzungsfläche begrenzt ist, und einen an den ersten Ausnehmungsbereich an dessen von der besagten Körperfläche abgewandter Seite anschließenden, im Querschnitt kleineren zweiten Ausnehmungsbereich aufweist, und bei dem in dem Datenträgerkörper Kanäle hergestellt werden, von denen jeder von der ringförmigen Begrenzungsfläche des ersten Ausnehmungsbereiches ausgehend durch den Datenträgerkörper hindurch bis zu einem Spulenanschlusskontakt reicht, hat sich weiters als sehr vorteilhaft erwiesen, wenn in dem hergestellten Datenträger mit einem, vorzugsweise mit demselben Materialabtragungsverfahren die abgestufte Ausnehmung und die Kanäle hergestellt werden und wenn der Modul mit dem Bauteil und den Modulanschlusskontakten voran in die Ausnehmung eingesetzt wird, wobei jeder mit dem Träger des Moduls verbundene Modulanschlusskontakt mit der in einen Kanal eingebrachten elektrisch leitenden Masse mit einem gegenüberliegenden Spulenanschlusskontakt in elektrisch leitende Verbindung gebracht wird und gegebenenfalls überschüssige elektrisch leitende Masse in die von einem Kanal seitlich weg verlaufende Tasche gedrückt wird. Ein solches Verfahren hat sich im Hinblick auf ein sehr preiswertes Herstellen eines Datenträgers als sehr günstig erwiesen.

Im Hinblick auf die Materialabtragung zum Herstellen der Ausnehmung und der Kanäle hat sich als besonders vorteilhaft erwiesen, wenn die Materialabtragung zum Herstellen der Ausnehmung und der Kanäle sowie der Taschen durch einen Fräsvorgang erfolgt. Auf diese Weise kann ein relativ großes Volumen an Material sehr schnell und sehr präzise abgetragen werden, wobei Toleranzen von nur einigen Mikrometern eingehalten werden können.

Bei den vorstehend angeführten erfindungsgemäßen Verfahren hat sich als besonders vorteilhaft erwiesen, wenn in jeden Kanal als elektrisch leitende Masse, die das elektrisch leitende Verbindungsmittel bildet, ein elektrisch leitendes Klebemittel eingebracht wird. Auf diese Weise ist erreicht, dass die elektrisch leitenden Verbindungsmittel nicht nur zur Bildung einer elektrisch leitenden Verbindung dienen, sondern zusätzlich auch zum mechanischen Festhalten eines Moduls an dem Datenträgerkörper eines Datenträgers, weil die elektrisch leitenden Klebemittel mit den Modulanschlusskontakten eine gute und feste Klebeverbindung eingehen und auf diese Weise den Modul am Datenträgerkörper festhalten.

Bei einem erfindungsgemäßen Verfahren, bei dem in einem hergestellten Datenträgerkörper eine Ausnehmung und von der Ausnehmung ausgehende Kanäle zu den Spulenanschlusskontakten hergestellt werden, hat sich als besonders vorteilhaft erwiesen, wenn vor dem Einbringen der elektrisch leitenden Masse in die Kanäle und vor dem Einsetzen des Moduls in die Ausnehmung durch die Kanäle hindurch mit den Spulenanschlusskontakten eine Prüfeinrichtung zum Prüfen der einwandfreien Funktionstüchtigkeit der Spule in Wirkverbindung gebracht wird. Hierdurch ist vorteilhafterweise erreicht, dass im Zuge des Herstellens eines Datenträgers die Spulenanschlusskontakte von außen her durch die Ausnehmung und die Kanäle hindurch zugänglich gemacht werden, so dass mit den Spulenanschlusskontakten die Anschlusskontakte einer Prüfeinrichtung in elektrisch leitende Verbindung bringbar sind und somit prüfbar ist, ob die in einem Datenträgerkörper aufgenommene und darin eingebettete Spule einwandfrei funktionstüchtig ist. Erst nach Erhalt eines positiven Prüfungsergebnisses wird der in Relation zu den übrigen Datenträgerbestandteilen teure Modul in den Datenträgerkörper eingesetzt. Hingegen wird bei einem negativen Prüfungsergebnis der Datenträgerkörper samt der darin eingebetteten defekten Spule, aber ohne eingesetzten Modul ausgeschieden, so dass kein Modul unnütz vergeudet wird, was im Hinblick auf möglichst geringe Ausschusskosten und folglich im Hinblick auf ein möglichst kostengünstiges Herstellen eines Datenträgers äußerst vorteilhaft ist.

Als sehr vorteilhaft hat sich bei einem erfindungsgemäßen Verfahren weiters erwiesen, wenn vor dem Einsetzen des Moduls in die Ausnehmung in einem Randbereich der zweiten Trägerhauptfläche des Trägers des Moduls ein Heißschmelz-Klebemittel aufgetragen wird und wenn nach dem Einsetzen des Moduls in die Ausnehmung auf die erste Trägerhauptfläche des Trägers des Moduls ein Heizstempel einer Heizvorrichtung zum Aktivieren des Heißschmelz-Klebemittels aufgesetzt wird. Dies ist hinsichtlich eines besonders sicheren Festhaltens des Moduls mittels seines Trägers an dem Datenträgerkörper vorteilhaft.

Als sehr vorteilhaft hat sich bei einem erfindungsgemäßen Verfahren auch noch erwiesen, wenn die Spulenwindungen und die Spulenanschlusskontakte der Spule auf eine Trägerfolie aufgebracht werden und wenn danach die Trägerfolie mit den auf ihr aufgebrachten Spulenwindungen und Spulenanschlusskontakten der Spule mit mindestens einer weiteren Folie gestapelt wird, wobei die Spulenwindungen und die Spulenanschlusskontakte der Spule zwischen der Trägerfolie und einer Deckfolie zu liegen kommen, und wenn danach die gestapelten Folien durch einen Laminiervorgang zum Herstellen des Datenträgerkörpers laminiert werden. Auf diese Weise ist erreicht, dass die von einer üblichen und gebräuchlichen Laminiertechnik her bekannten Vorteile auch bei einem erfindungsgemäßen Verfahren ausgenützt werden.

Im vorstehend angeführten Zusammenhang hat sich als besonders vorteilhaft erweisen, wenn als Trägerfolie, auf die die Spulenwindungen und die Spulenanschlusskontakte der Spule aufgebracht werden, eine aus Polycarbonat bestehende Folie verwendet wird. Eine solche Folie aus Polycarbonat hat sich in der Praxis als besonders vorteilhaft erwiesen, weil beim Laminiervorgang die Spule samt ihren Spulenanschlusskontakten in eine solche Folie gleichmäßig eingedrückt wird und folglich die Spule samt ihren Spulenanschlusskontakten praktisch ohne mechanische Belastungen und Spannungen im fertiggestellten Datenträgerkörper eingebettet ist.

Hierbei hat sich weiters als sehr vorteilhaft erwiesen, wenn als Deckfolie, die beim Stapeln der Folien den Spulenwindungen und den Spulenanschlusskontakten der Spule unmittelbar gegenüberliegt, eine aus Polyvinylchlorid bestehende Folie verwendet wird. Mit einer solchen Folie aus Polyvinylchlorid als Deckfolie wird das gleichmäßige Eindrücken und Einbetten der Spule günstig unterstützt.

Hierbei hat sich weiters auch noch als sehr vorteilhaft erwiesen, wenn die Spulenwindungen und die Spulenanschlusskontakte der Spule durch Aufbringen eines leitfähigen Materials auf die Trägerfolie in einem Siebdruckvorgang hergestellt werden. Auf diese Weise sind die Vorteile von Siebdruckverfahren, deren Anwendung zum Herstellen von Spulen für Datenträger an sich bekannt ist, auch bei einem erfindungsgemäßen Verfahren vorteilhafterweise ausgenützt.

Im vorstehend angeführten Zusammenhang hat sich weiters als sehr vorteilhaft erwiesen, wenn die Spulenwindungen und die Spulenanschlusskontakte der Spule durch Aufbringen einer Silberleitpaste auf die Trägerfolie in einem Siebdruckvorgang hergestellt werden. Dies erweist sich in der Praxis als besonders günstig.

Die vorstehend angeführten Aspekte und weitere Aspekte der Erfindung gehen aus den nachfolgend beschriebenen Ausführungsbeispielen hervor und sind anhand dieser Ausführungsbeispiele erläutert.

Die Erfindung wird im Folgenden anhand von vier in den Zeichnungen dargestellten Ausführungsbeispielen weiter erläutert, auf die die Erfindung aber nicht beschränkt ist.
Die Figur 1 zeigt in einem Querschnitt gemäß der Linie I-I in der Figur 2 einen Teil einer großflächigen Trägerfolie, auf der eine Vielzahl von Spulen angebracht sind, von denen nur eine Spule mit ihren Spulenwindungen und mit ihren beiden Spulenanschlusskontakten dargestellt ist.
Die Figur 2 zeigt in einem Schnitt gemäß der Linie II-II in der Figur 1 eine auf die großflächige Trägerfolie aufgebrachte Spule mit ihren Spulenwindungen und mit ihren beiden Spulenanschlusskontakten.
Die Figur 3 zeigt analog wie die Figur 1 einen Folienstapel, der aus insgesamt sechs großflächigen Folien besteht und der die großflächige Trägerfolie gemäß der Figur 1 enthält.
Die Figur 4 zeigt analog wie die Figuren 1 und 3 einen großflächigen Folienkörper, der durch Laminieren des Folienstapels gemäß der Figur 3 erhalten wird und in den eine Vielzahl von Spulen samt ihren Spulenanschlusskontakten eingebettet sind.
Die Figur 5 zeigt analog wie die Figuren 1, 3 und 4 einen Kartenkörper einer Chipkarte, der durch Ausstanzen aus dem Folienkörper gemäß der Figur 4 erhalten wird und in den eine Spule samt ihren beiden Spulenanschlusskontakten eingebettet ist.
Die Figur 6 zeigt analog wie die Figuren 1, 3 , 4 und 5 den Kartenkörper gemäß der Figur 5, der eine Ausnehmung und zwei von der Ausnehmung bis zu den beiden Spulenanschlusskontakten reichende Kanäle aufweist.
Die Figur 7 zeigt analog wie die Figuren 1, 3, 4, 5 und 6 den Kartenkörper gemäß der Figur 6, wobei in die Kanäle ein elektrisch leitendes Klebemittel eingebracht ist und ein Modul sich über der Ausnehmung in dem Kartenkörper befindet.
Die Figur 8 zeigt analog wie die Figuren 1, 3, 4, 5, 6 und 7 eine fertiggestellte Chipkarte als Datenträger gemäß einem ersten Ausführungsbeispiel der Erfindung, bei der in die Ausnehmung ihres Kartenkörpers ein Modul eingesetzt ist.
Die Figur 9 zeigt analog wie die Figur 8, jedoch ausschnittsweise und in einem gegenüber der Figur 8 etwa vierfach größeren Maßstab die fertiggestellte Chipkarte mit dem in die Ausnehmung eingesetzten Modul, wobei zwei Modulanschlusskontakte und die beiden Spulenanschlusskontakte je in einer senkrecht zu den Körperhauptflächen und senkrecht zu den Trägerhauptflächen verlaufenden Richtung einander gegenüberliegen und mit einem je in einem Kanal enthaltenen elektrisch leitenden Klebemittel elektrisch leitend miteinander verbunden sind.
Die Figur 10 zeigt analog wie die Figur 9 eine fertiggestellte Chipkarte als Datenträger gemäß einem zweiten Ausführungsbeispiel der Erfindung, die einen ebenfalls in einer Laminiertechnik hergestellten Kartenkörper aufweist und bei der zwei Modulanschlusskontakte und zwei Spulenanschlusskontakte je in einer schräg zu den Körperhauptflächen und schräg zu den Trägerhauptflächen verlaufenden Richtung einander gegenüberliegen und mit einem je in einem Kanal enthaltenen elektrisch leitenden Klebemittel elektrisch leitend miteinander verbunden sind.

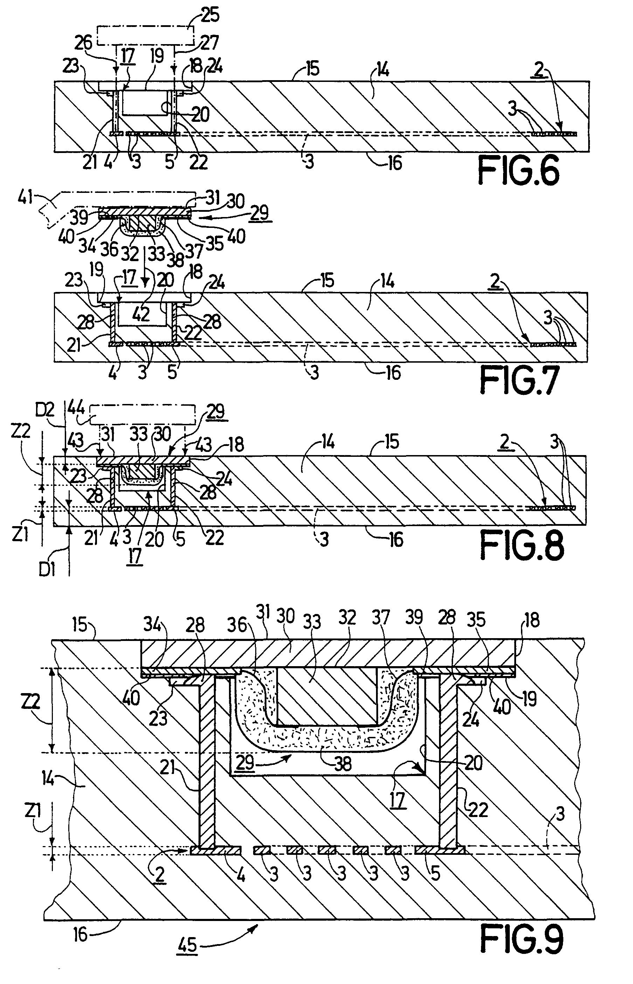

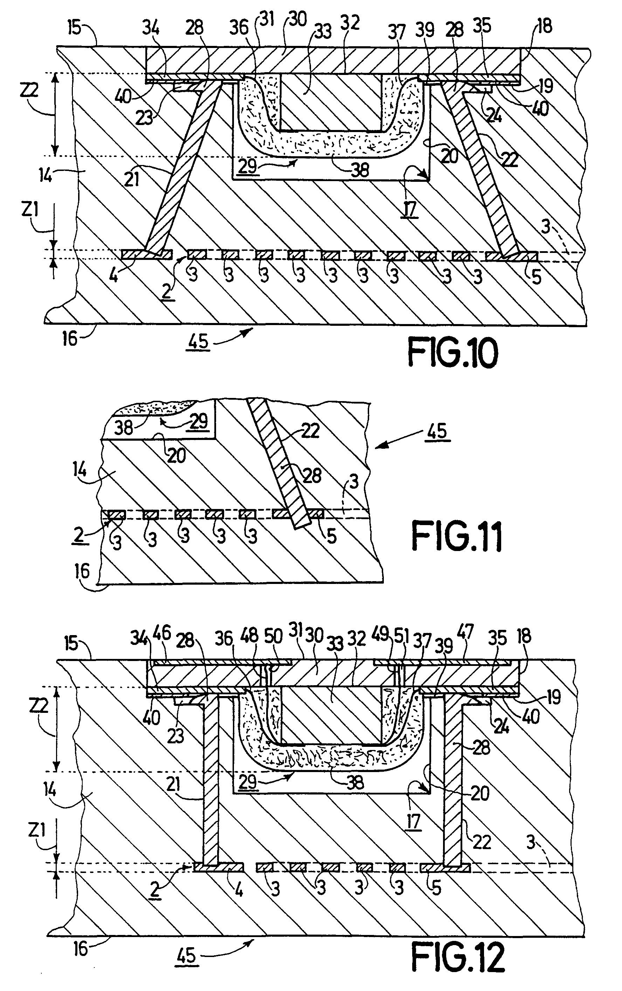

Die Figur 11 zeigt analog wie die Figuren 9 und 10, jedoch nur ausschnittsweise eine fertiggestellte Chipkarte als Datenträger gemäß einem dritten Ausführungsbeispiel der Erfindung, die einen in einer Kunststoff-Spritzgusstechnik hergestellten Kartenkörper aufweist und bei der zwei Modulanschlusskontakte und zwei Spulenanschlusskontakte je in einer schräg zu den Körperhauptflächen und schräg zu den Trägerhauptflächen verlaufenden Richtung einander gegenüberliegen und mit einem je in einem Kanal enthaltenen elektrisch leitenden Klebemittel elektrisch leitend miteinander verbunden sind, wobei die beiden Kanäle die beiden Spulenanschlusskontakte durchsetzen.
Die Figur 12 zeigt analog wie die Figuren 9 und 10 eine fertiggestellte Chipkarte als Datenträger gemäß einem vierten Ausführungsbeispiel der Erfindung, die einen ebenfalls in einer Kunststoff-Spritzgußtechnik hergestellten Kartenkörper aufweist und bei der zwei Modulanschlusskontakte und zwei Spulenanschlusskontakte je in einer senkrecht zu den Körperhauptflächen und senkrecht zu den Trägerhauptflächen verlaufenden Richtung einander gegenüberliegen und mit einem je in einem Kanal enthaltenen elektrisch leitenden Klebemittel elektrisch leitend miteinander verbunden sind und bei der an dem Träger des Moduls zusätzlich weitere Modulanschlusskontakte vorgesehen sind, die von außen her zugänglich sind.

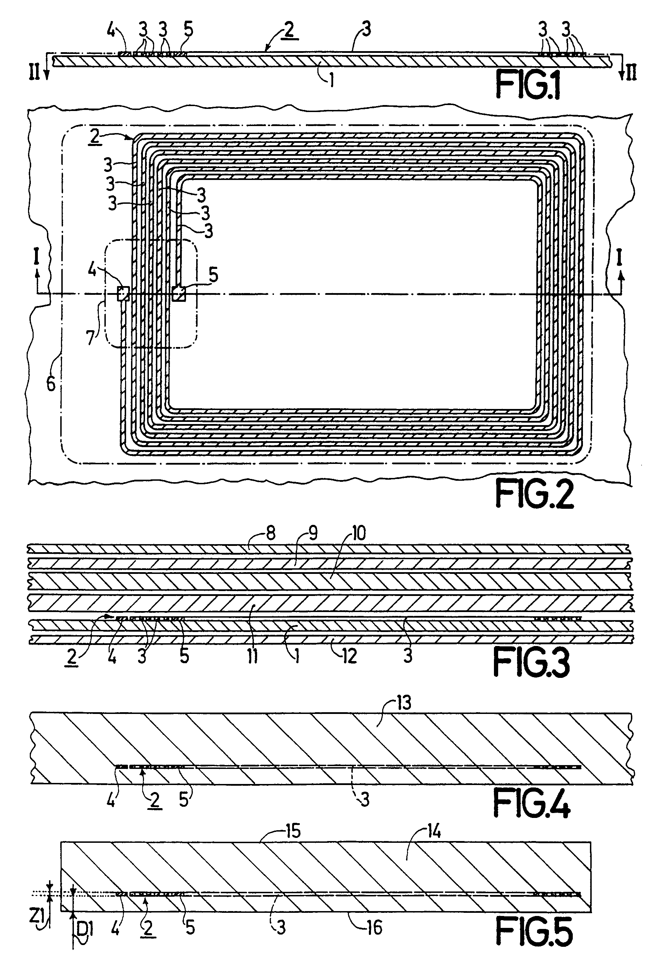

Nachfolgend wird vorerst anhand der Figuren 1 bis 8 eine mögliche Variante eines erfindungsgemäßen Verfahrens zum Herstellen eines erfindungsgemäßen Datenträgers beschrieben, der als Chipkarte ausgebildet ist.

Bei einem ersten Verfahrensschritt wird eine in der Figur 1 dargestellte großflächige Trägerfolie 1 einer Siebdruckeinrichtung zugeführt. Die Trägerfolie 1 weist eine Flächenabmessung von 530 mm x 660 mm auf. Die Dicke der Trägerfolie 1 beträgt etwa 125 µm. Die Trägerfolie 1 besteht aus Polycarbonat, was sich bei dem hier beschriebenen Verfahren als sehr vorteilhaft erwiesen hat.

In einem nachfolgenden Verfahrensschritt werden in der Siebdruckeinrichtung in einer Siebdrucktechnik durch Aufbringen eines leitfähigen Materials, im vorliegenden Fall durch Aufbringen einer Silberleitpaste, auf die Trägerfolie 1 eine Mehrzahl von Spulen 2 aufgebracht, die im vorliegenden Fall je insgesamt sechs durch Leiterbahnen gebildete Spulenwindungen 3 aufweisen. Es sei erwähnt, dass die Anzahl und die Form der Spulenwindungen 3 der Spulen 2 auch anders gewählt sein können. Im vorliegenden Fall werden zugleich achtundvierzig Spulen auf die großflächige Trägerfolie 1 aufgebracht, von denen in den Figuren 1 und 2 aber nur eine Spule 2 dargestellt ist. Am freien Ende der äußersten Spulenwindung und am freien Ende der innersten Spulenwindung jeder Spule 2 ist je ein rechteckförmiger Spulenanschlusskontakt 4 bzw. 5 vorgesehen. Die beiden Spulenanschlusskontakte 4 und 5 sind ebenfalls durch Leiterbahnen gebildet, die analog wie die Spulenwindungen 3 auf die Trägerfolie 1 aufgebracht werden. Die Dicke der Spulenwindungen 3 bzw. der Spulenanschlusskontakte 4 und 5 der Spule 2 beträgt etwa 25 µm. Um diese Dicke mittels einer üblichen Siebdrucktechnik zu erreichen, können auch mehrere Druckvorgänge durchgeführt werden, wobei bei jedem nachfolgenden Druckvorgang Silberleitpaste auf die beim jeweils vorherigen Druckvorgang aufgebrachte Silberleitpaste aufgetragen wird, so dass durch das mehrmalig übereinander erfolgende Auftragen von Silberleitpaste in einem Siebdruckvorgang die gewünschte Höhe der Spulenwindungen 3 und der Spulenanschlusskontakte 4 und 5 der Spule 2 erreicht werden.

Durch das vorstehend erläuterte Aufbringen der Spulen 2 auf die Trägerfolie 1 wird das in den Figuren 1 und 2 dargestellte Zwischenprodukt erhalten.

Bezüglich der Figur 2 ist noch zu erwähnen, dass in derselben mit einer strichpunktierten Linie 6 die Umrisskontur einer herzustellenden Chipkarte und mit einer weiteren strichpunktierten Linie 7 die Umrisskontur eines Trägers eines einen Chip als Bauteil enthaltenden Moduls dargestellt sind.

Bei einem nächsten Verfahrensschritt wird - wie dies in der Figur 3 schematisch dargestellt ist - die großflächige Trägerfolie 1 mit den auf ihr aufgebrachten Spulen 2 mit insgesamt im vorliegenden Fall fünf weiteren Folien 8, 9, 10, 11 und 12 gestapelt, wobei die Spulen 2 und somit auch ihre Spulenanschlusskontakte 4 und 5 zwischen der Trägerfolie 1 und einer Deckfolie 11 zu liegen kommen. Bezüglich der Deckfolie 11 ist zu erwähnen, dass es sich hierbei um eine Folie aus Polyvinylchlorid handelt, die eine Dicke von etwa 200 µm aufweist. Die Flächenabmessungen der weiteren Folien 8, 9, 10, 11 und 12 stimmen mit der Flächenabmessung der Trägerfolie 1 nominal überein.

Bezüglich der Folie 12, die an der von den Spulen 2 abgewandten Flächenseite der Trägerfolie 1 liegt, ist noch zu erwähnen, dass es sich hierbei ebenfalls um eine Folie aus Polyvinylchlorid handelt, die aber eine Dicke von nur etwa 100 µm aufweist. Die Folie 8 besteht ebenso wie die Folie 12 aus Polyvinylchlorid und weist ebenso wie die Folie 12 eine Dicke von etwa 100 µm auf. Die Folie 9 besteht ebenso wie die Trägerfolie 1 aus Polycarbonat und weist ebenso wie die Trägerfolie 1 eine Dicke von etwa 125 µm auf. Die Folie 10 besteht ebenso wie die Folie 11 aus Polyvinylchlorid und weist ebenso wie die Folie 11 eine Dicke von etwa 200 µm auf.

Nach dem wie aus der Figur 3 ersichtlichen Stapeln der Folien 8, 9, 10, 11, 1 und 12 werden in einem nächsten Verfahrensschritt die gestapelten Folien durch einen Laminiervorgang laminiert. Bei diesem Laminiervorgang werden die Folien 8, 9, 10, 11, 1 und 12 unter Einwirkung von Druck und Hitze miteinander verbunden, wobei durch ein kontrolliertes Verschmelzen der einzelnen Folien miteinander ein sogenanntes Homogenisieren der Folien erfolgt, so dass ein großflächiger Folienkörper 13 erhalten wird, wie dieser in der Figur 4 dargestellt ist. In dem großflächigen Folienkörper 13 mit den Flächenabmessungen von 530 mm x 660 mm sind eine Mehrzahl von Spulen 2 eingebettet, wie dies für eine Spule 2 in der Figur 4 dargestellt ist.

In einem nachfolgenden Verfahrensschritt werden mit einem Stanzwerkzeug in einem Stanzvorgang aus dem großflächigen Folienkörper 13 eine Mehrzahl von als Datenträgerkörper anzusehenden Kartenkörpern 14 ausgestanzt. Im vorliegenden Fall werden aus einem Folienkörper insgesamt achtundvierzig Kartenkörper 14 ausgestanzt, von denen einer in der Figur 5 dargestellt ist. Das Ausstanzen des in der Figur 5 dargestellten Kartenkörpers 14 aus dem großflächigen Folienkörper 13 wird entlang der in der Figur 2 mit dem Bezugszeichen 6 bezeichneten strichpunktierten Linie vorgenommen.

Der Kartenkörper 14 ist von einer ersten Körperhauptfläche 15 und von einer zu der ersten Körperhauptfläche 15 parallelen zweiten Körperhauptfläche 16 begrenzt. In dem Kartenkörper 14 ist die Spule 2 eingebettet, wobei im vorliegenden Fall sowohl die Spulenwindungen 3 der Spule 2 als auch die Spulenanschlusskontakte 4 und 5 der Spule 2 parallel zu den beiden Körperhauptflächen 15 und 16 verlaufend in den Kartenkörper 14 aufgenommen sind und in einem sich quer, in diesem Fall senkrecht zu der ersten Körperhauptfläche 15 und in diesem Fall auch zu der zweiten Körperhauptfläche 16 erstreckenden Windungsniveaubereich Z1 des Kartenkörpers 14 liegen. Im vorliegenden Fall liegt der Windungsniveaubereich Z1, in dem die Spule 2 liegt, in einem Abstand D1 von der zweiten Körperhauptfläche 16. Der Abstand D1 weist hierbei einen Wert von etwa 200 µm auf.

In einem nachfolgenden Verfahrensschritt wird mit einem Fräswerkzeug in einem Fräsvorgang in dem hergestellten Kartenkörper 14 durch Materialabtragung eine abgestufte Ausnehmung 17 hergestellt, wie dies aus der Figur 6 ersichtlich ist. Die Ausnehmung 17 mündet in die erste Körperhauptfläche 15. Bei dem vorerwähnten Fräsvorgang werden hierbei zwei Frässchritte durchgeführt, wodurch eine Ausnehmung 17 gebildet wird, die einen an die erste Körperhauptfläche 15 angrenzenden, im Querschnitt größeren ersten Ausnehmungsbereich 18, der unter anderem durch eine parallel zu der ersten Körperhauptfläche 15 verlaufende ringförmige Begrenzungsfläche 19 begrenzt ist, und einen an den ersten Ausnehmungsbereich 18 an dessen von der ersten Körperhauptfläche 15 abgewandter Seite anschließenden, im Querschnitt kleineren zweiten Ausnehmungsbereich 20 aufweist.

In einem dritten Frässchritt und in einem vierten Frässchritt des vorerwähnten Fräsvorganges werden in dem Kartenkörper 14 durch Materialabtragung zwei Kanäle 21 und 22 hergestellt, von denen jeder von der ringförmigen Begrenzungsfläche 19 des ersten Ausnehmungsbereiches 18 ausgehend durch den Kartenkörper 14 hindurch bis zu einem Spulenanschlusskontakt 4 bzw. 5 reicht. Die beiden Kanäle 21 und 22 verlaufen hierbei quer zu der ersten Körperhauptfläche 15 und der zweiten Körperhauptfläche 16 des Kartenkörpers 14, und zwar im vorliegenden Fall senkrecht zu den beiden Körperhauptflächen 15 und 16, und sind über ihre gesamte Länge von dem Kartenkörper 14 umgeben. Die beiden Kanäle 21 und 22 sind über ihre von den beiden Spulenanschlusskontakten 4 und 5 abgewandten Enden von außen her zugänglich. Jeder Kanal 21 bzw. 22 weist an seinem von dem an ihn angrenzenden Spulenanschlusskontakt 4 bzw. 5 abgewandten Ende eine von dem betreffenden Kanal 21 bzw. 22 seitlich weg verlaufende Tasche 23 bzw. 24 auf, die im Zuge des dritten und vierten Frässchrittes hergestellt werden.

In einem nachfolgenden Verfahrensschritt wird durch die Ausnehmung 17 und durch die beiden Kanäle 21 und 22 hindurch mit den beiden Spulenanschlusskontakten 4 und 5 der Spule 2 eine in der Figur 6 schematisch mit einer strichpunktierten Linie angedeutete Prüfeinrichtung 25 zum Prüfen der einwandfreien Funktionstüchtigkeit der Spule 2 in Wirkverbindung gebracht. Dies erfolgt in der Weise, dass zwei in der Figur 6 schematisch je mit einem strichpunktierten Pfeil dargestellte Prüfkontakte 26 und 27 der Prüfeinrichtung 25 mit den beiden Spulenanschlusskontakten 4 und 5 in leitende Verbindung gebracht werden. Mit der Prüfeinrichtung 25 ist die einwandfreie Funktionstüchtigkeit der Spule 2 feststellbar. Wenn mit der Prüfeinrichtung 25 eine fehlerhafte bzw. funktionsuntüchtige Spule 2 festgestellt wird, dann wird der betreffende Kartenkörper 14 samt der darin eingebetteten defekten Spule 2 ausgeschieden. Wenn mit der Prüfeinrichtung 25 ein positives Prüfergebnis hinsichtlich der einwandfreien Funktionstüchtigkeit der Spule 2 festgestellt wird, dann wird der betreffende Kartenkörper 14 samt der darin eingebetteten Spule 2 zum Herstellen einer Chipkarte weiterverwendet.

Bei einem weiteren Verfahrensschritt wird mit einer sogenannten Dispensereinrichtung in die beiden Kanäle 21 und 22 ein elektrisch leitendes Klebemittel als elektrisch leitendes Verbindungsmittel 28 eingebracht, wie dies in der Figur 7 dargestellt ist.

Bereits vor dem Einbringen des als elektrisch leitendes Verbindungsmittel 28 vorgesehenen Klebemittels in die beiden Kanäle 21 und 22 wird bei dem hier beschriebenen Verfahren ein sogenannter Modul in Bearbeitung genommen. Ein solcher Modul 29 ist in der Figur 7 schematisch dargestellt.

Der Modul 29 weist einen plattenförmigen Träger 30 auf. Der Träger 30 ist von einer ersten Trägerhauptfläche 31 und von einer zu der ersten Trägerhauptfläche 31 parallelen zweiten Trägerhauptfläche 32 begrenzt. Die Flächenabmessungen des Trägers 30 stimmen mit den Querschnittsabmessungen des ersten Ausnehmungsbereiches 18 im wesentlichen überein bzw. sind sie nur geringfügig kleiner. Die Umrisskonturen des ersten Ausnehmungsbereiches 18 und des Trägers 30 entsprechen dem in der Figur 2 mit der strichpunktierten Linie 7 dargestellten Verlauf.

Der Modul 29 weist weiters einen Chip 33 als Bauteil auf, bei dem es sich in bekannter Weise um einen integrierten Baustein handelt. Der Chip 33 ist mit dem Träger 30 verbunden, und zwar an der zweiten Trägerhauptfläche 32 des Trägers 30 beispielsweise mit einer Klebeverbindung. Wie aus der Figur 7 ersichtlich ist, ist somit der Chip 33 gegenüber der zweiten Trägerhauptfläche 32 erhaben.

Weiters weist der Modul 29 zwei mit dem Träger 30 verbundene, im Bereich der zweiten Trägerhauptfläche 32 sich befindende, zum Zusammenwirken mit den beiden Spulenanschlusskontakten 4 und 5 vorgesehene Modulanschlusskontakte 34 und 35 auf. Die beiden Modulanschlusskontakte 34 und 35 sind hierbei plattenförmig ausgebildet und durch an dem Träger 30 angebrachte Leiterbahnen gebildet. Die beiden Modulanschlusskontakte 34 und 35 sind - was in der Figur 7 nur schematisch dargestellt ist - über je einen sogenannten Bonddraht 36 und 37 mit in der Figur 7 nicht dargestellten Chipanschlusskontakten des Chips 33 elektrisch leitend verbunden, die in Fachkreisen häufig als Pads bezeichnet werden.

Zu erwähnen ist noch, dass der Chip 33 und die beiden Bonddrähte 36 und 37 sowie ein Teil der beiden Modulanschlusskontakte 34 und 35 in eine Umhüllung 38 eingebettet sind, die durch eine aus Kunstharz bestehende Vergussmasse gebildet ist.

Ein wie vorstehend beschriebener Modul 29 wird beispielsweise von einem Hersteller solcher Module in hoher Stückzahl angeliefert, wobei diese Module beispielsweise in einer sogenannten Gurtverpackung angeliefert werden.

Im Zuge des hier beschriebenen Verfahrens wird bei einem weiteren Verfahrensschritt in einem ringförmigen Abschnitt 39 der zweiten Trägerhauptfläche 32 des Trägers 30, welcher Abschnitt 39 einen Randbereich bildet, ein Heißschmelz-Klebemittel 40 aufgetragen, wie dies in der Figur 7 angedeutet ist.

Danach wird in einem weiteren Verfahrensschritt der Modul 29 mit Hilfe eines in der Figur 7 schematisch mit strichpunktierten Linien angedeuteten Bondarmes 41 mit dem Chip 33 und den beiden Modulanschlusskontakten 34 und 35 voran in Richtung des Pfeiles 42 in die Ausnehmung 17 eingesetzt. Hierbei treten gegen Ende dieses Einsetzvorganges die beiden plattenförmigen Modulanschlusskontakte 34 und 35 mit dem als elektrisch leitendes Verbindungsmittel 28 vorgesehenen elektrisch leitenden Klebemittel in Kontakt. Über das in die beiden Kanäle 21 und 22 eingebrachte Klebemittel werden hierbei die beiden Modulanschlusskontakte 34 und 35 mit den beiden Spulenanschlusskontakten 4 und 5 in elektrisch leitende und auch in mechanisch feste Verbindung gebracht. Beim Einsetzen des Moduls 29 in die Ausnehmung 17 wird gegebenenfalls überschüssiges elektrisch leitendes Klebemittel von den beiden Modulanschlusskontakten 34 und 35 im Bereich der beiden Taschen 23 und 24 aus den beiden Kanälen 21 und 22 herausgedrückt, so dass überschüssiges elektrisch leitendes Klebemittel in den beiden Taschen 23 und 24 aufgenommen wird, wie dies in den Figuren 8 und 9 dargestellt ist. Nach dem Einsetzen des Moduls 29 in die Ausnehmung 17 des Kartenkörpers 14 ist der in der Figur 8 dargestellte Verfahrensstand erhalten.

In einem weiteren Verfahrensschritt wird auf die erste Trägerhauptfläche 31 des Trägers 30 ein in der Figur 8 schematisch mit zwei Pfeilen angedeuteter Heizstempel 43 einer in der Figur 8 schematisch mit strichpunktierten Linien angedeuteten Heizvorrichtung 44 zum Aktivieren des Heißschmelz-Klebemittels 40 aufgesetzt. Danach wird von dem aufgesetzten Heizstempel 43 Hitze über den Träger 30 bis zu dem Heißschmelz-Klebemittel 40 übertragen, wonach dann der Heizstempel 43 von dem Träger 30 wieder abgehoben wird. Beim nachfolgenden Abkühlen wird zwischen dem ringförmigen Randbereich 39 des Trägers 30 und der parallel zu den beiden Körperhauptflächen 15 und 16 verlaufenden ringförmigen Begrenzungsfläche 19 der Ausnehmung 17 eine Klebeverbindung gebildet, mit der der Modul 29 an dem Kartenkörper 14 festgehalten wird. Zum Festhalten des Moduls 29 an dem Kartenkörper 14 kann auch ein Klebemittel aus dem Gebiet der sogenannten Kaltklebetechnik zum Einsatz kommen.

Nach dem zuletzt beschriebenen Verfahrensschritt ist eine fertiggestellte Chipkarte 45 als Datenträger gemäß einem ersten Ausführungsbeispiel der Erfindung erhalten. Diese Chipkarte 45 ist ausschnittsweise in der Figur 9 dargestellt.

Durch das Einsetzen des Moduls 29 in die Ausnehmung 17 des Kartenkörpers 14 kommt die erste Trägerhauptfläche 31 des Trägers 30 der ersten Körperhauptfläche 15 des Kartenkörpers 14 zugewandt zu liegen, wobei im vorliegenden Fall die erste Trägerhauptfläche 31 mit der ersten Körperhauptfläche 15 fluchtet. Weiters kommt die zweite Trägerhauptfläche 32 des Trägers 30 von der ersten Körperhauptfläche 15 des Kartenkörpers 14 abgewandt und der zweiten Körperhauptfläche 16 des Kartenkörpers 14 zugewandt zu liegen. Weiters kommt der als Bauteil vorgesehene Chip 33 in einem sich quer, in diesem Fall senkrecht zu der ersten Körperhauptfläche 15 und in diesem Fall auch senkrecht zu der zweiten Körperhauptfläche 16 des Kartenkörpers 14 erstreckenden Bauteilniveaubereich Z2 des Kartenkörpers 14 zu liegen. Im vorliegenden Fall liegt der Bauteilniveaubereich Z2 in einem Abstand D2 von der ersten Körperhauptfläche 15. Der Abstand D2 weist hierbei einen Wert von etwa 100 µm auf. Im vorliegenden Fall, in dem der Chip 33 in einer Umhüllung 38 eingebettet ist, erstreckt sich der Bauteilniveaubereich Z2 des Kartenkörpers 14 über den gesamten Höhenbereich der Umhüllung 38. Für den Fall, dass ein Modul zum Einsatz kommt, bei dem der als Bauteil vorgesehene Chip von keiner Umhüllung umgeben ist bzw. bei dem die Umhüllung praktisch niveaugleich mit dem Chip ausgebildet ist, ist es ausreichend, wenn der Bauteilniveaubereich Z2 sich nur bis zu dem von der zweiten Trägerhauptfläche des Trägers abgewandten Endniveaubereich des Chips erstreckt.

Wie aus der Figur 9 ersichtlich ist, ist bei der Chipkarte 45 vorteilhafterweise die Ausbildung so getroffen, dass die Spulenwindungen 3 der Spule 2 und im vorliegenden Fall zusätzlich auch die beiden Spulenanschlusskontakte 4 und 5 der Spule 2 in einem außerhalb des Bauteilniveaubereiches Z2 liegenden Windungsniveaubereich Z1 liegen und dass die beiden Modulanschlusskontakte 34 und 35 über den Bauteilniveaubereich Z2 hindurch und im vorliegenden Fall auch über den Bauteilniveaubereich Z2 hinaus mit Hilfe des in den beiden Kanälen 21 und 22 enthaltenen, als elektrisch leitendes Verbindungsmittel 28 vorgesehenen elektrisch leitenden Klebemittels mit den beiden Spulenanschlusskontakten 4 und 5 sowohl elektrisch als auch mechanisch gut verbunden sind. Aufgrund dieser Ausbildung ist vorteilhafterweise erreicht, dass - trotzdem der Chip 33 und seine Umhüllung 38 und die beiden Modulanschlusskontakte 34 und 35 von derselben Trägerhauptfläche, nämlich der zweiten Trägerhauptfläche 32 des Trägers 30 des Moduls 29 abstehen - der Verlauf der Spulenwindungen 3 der Spule 2 und die Ausbildung der Spule 2 in der Umgebung des als Bauteil vorgesehenen Chips 33 keinen einschränkenden Einflüssen durch die Anwesenheit des Chips 33 unterliegen, weil der Chip 33 samt seiner Umhüllung 38 in einem gänzlich anderen Niveaubereich liegt als die Spulenwindungen 3 der Spule 2 und die beiden Spulenanschlusskontakte 4 und 5 der Spule 2. Aufgrund der Tatsache, dass bei der Chipkarte 45 sowohl die elektrische Verbindung zwischen den Modulanschlusskontakten 34 und 35 und den Spulenanschlusskontakten 4 und 5 als auch die mechanische Verbindung dieser Kontakte mit Hilfe des als elektrisch leitendes Verbindungsmittel 28 vorgesehenen elektrisch leitenden Klebemittels erfolgt, ist eine sichere und alterungsbeständige Verbindung zwischen den beiden Modulanschlusskontakten 34 und 35 und den beiden Spulenanschlusskontakten 4 und 5 gewährleistet.

In der Figur 10 ist eine Chipkarte 45 als Datenträger gemäß einem zweiten Ausführungsbeispiel der Erfindung dargestellt. Bei dieser Chipkarte 45 sind zwei Kanäle 21 und 22 vorgesehen, die hierbei quer zu der ersten Körperhauptfläche 15 und der zweiten Körperhauptfläche 16 des Kartenkörpers 14 verlaufen, und zwar im vorliegenden Fall in der Weise schräg zu den beiden Körperhauptflächen 15 und 16, dass der Abstand zwischen den beiden Kanälen 21 und 22 im Bereich der beiden Spulenanschlusskontakte 4 und 5 größer ist als im Bereich der beiden Modulanschlusskontakte 34 und 35. Aufgrund dieser Ausbildung der beiden Kanäle 21 und 22 ist vorteilhafterweise erreicht, dass zwischen den beiden Spulenanschlusskontakten 4 und 5 eine größere Anzahl von Spulenwindungen 3 untergebracht werden kann, als dies bei einer Chipkarte 45 gemäß der Figur 9 der Fall ist.

In der Figur 11 ist eine Chipkarte 45 als Datenträger gemäß einem dritten Ausführungsbeispiel der Erfindung dargestellt. Bei dieser Chipkarte 45 weisen die beiden Kanäle, von denen die Figur 11 nur den Kanal 22 zeigt, ebenfalls einen geneigten Verlauf gegenüber der ersten Körperhauptfläche 15 und der zweiten Körperhauptfläche 16 der Chipkarte 45 auf. Bei der Chipkarte 45 gemäß der Figur 11 durchsetzen die beiden Kanäle die beiden Spulenanschlusskontakte, von denen die Figur 11 nur den Spulenanschlusskontakt 5 zeigt. Das Durchsetzen der Spulenanschlusskontakte durch die Kanäle ist dadurch erhalten, dass beim Herstellen der Chipkarte 45 die Kanäle über die Spulenanschlusskontakte hinaus ausgefräst werden. Der Vorteil einer solchen Ausbildung liegt darin, dass die Tiefe der Fräsvorgänge zum Herstellen der Kanäle relativ unkritisch ist und folglich eine weniger hohe Präzision erfordert. Durch das Einbringen des als elektrisch leitendes Verbindungsmittel 28 vorgesehenen elektrisch leitenden Klebemittels, das mit den von den Kanälen durchsetzten Spulenanschlusskontakten eine satte Verbindung eingeht, ist auch in diesem Fall eine einwandfreie elektrische und auch mechanische Verbindung zwischen den Spulenanschlusskontakten und den Modulanschlusskontakten mit Hilfe des in den Kanälen enthaltenen elektrisch leitenden Klebemittels realisiert.

In der Figur 12 ist eine Chipkarte 45 als Datenträger gemäß einem vierten Ausführungsbeispiel der Erfindung dargestellt. Bei dieser Chipkarte 45 ist die Ausbildung der beiden Kanäle 21 und 22 und die Ausbildung der beiden Spulenanschlusskontakte 4 und 5 und der beiden Modulanschlusskontakte 34 und 35, die über das in den beiden Kanälen 21 und 22 enthaltene elektrisch leitende Klebemittel miteinander verbunden sind, ident mit der Ausbildung dieser Chipkartenbestandteile bei der Chipkarte 45 gemäß der Figur 9.

Bei der Chipkarte 45 gemäß der Figur 12 sind aber mit dem Träger 30 des Moduls 29 zusätzlich im Bereich seiner ersten Trägerhauptfläche 31 vorgesehene weitere Modulanschlusskontakte verbunden, die zum Zusammenwirken mit von außerhalb der Chipkarte 45 mit ihnen in Kontaktverbindung bringbaren Gegenkontakten ausgebildet sind. Insgesamt sind bei der Chipkarte 45 gemäß der Figur 12 acht solche weitere Modulanschlusskontakte vorgesehen, von denen in der Figur 12 aber nur zwei weitere Modulanschlusskontakte 46 und 47 dargestellt sind. Die weiteren Modulanschlusskontakte sind - wie dies für die beiden weiteren Modulanschlusskontakte 46 und 47 aus der Figur 12 ersichtlich ist - über weitere Bonddrähte mit weiteren nicht dargestellten Chipanschlusskontakten (Pads) des Chips 33 verbunden, von denen in der Figur 12 die beiden weiteren Bonddrähte 48 und 49 dargestellt sind. Die weiteren Bonddrähte sind hierbei durch in dem Träger 30 vorgesehene Bohrungen hindurchgeführt, von denen in der Figur 12 zwei Bohrungen 50 und 51 dargestellt sind.

Bei dem als Bauteil vorgesehenen Chip 33 der Chipkarte 45 gemäß der Figur 12 handelt es sich um einen sogenannten Doppel-Zweck-Chip, dessen im Bereich der zweiten Trägerhauptfläche 32 vorgesehene Modulanschlusskontakte 34 und 35 mit den Spulenanschlusskontakten 4 und 5 der Spule 2 verbunden sind, die zum berührungslosen Datenaustausch zwischen dem Doppel-Zweck-Chip und einer Schreib/Lese-Station und gegebenenfalls zur berührungslosen Energieübertragung zu dem Doppel-Zweck-Chip vorgesehen ist, und dessen im Bereich der ersten Trägerhauptfläche 31 vorgesehene weitere Modulanschlusskontakte zum kontaktbehafteten Datenaustausch zwischen dem Doppel-Zweck-Chip und einer Schreib/Lese-Station und zur kontaktbehafteten Energieübertragung zu dem Doppel-Zweck-Chip vorgesehen sind.

Auch bei der Chipkarte 45 gemäß der Figur 12 liegen der als Bauteil vorgesehene Chip 33 samt seiner Umhüllung 38 und die Spule 2 mit ihren Spulenwindungen 3 und mit ihren beiden Spulenanschlusskontakten 4 und 5 in unterschiedlichen Niveaubereichen, nämlich der als Bauteil vorgesehene Chip 33 samt seiner Umhüllung 38 in dem Bauteilniveaubereich Z2 und die Spule 2 in dem Windungsniveaubereich Z1, was auch bei der Chipkarte 45 gemäß der Figur 12 den großen Vorteil bringt, dass - trotzdem der Chip 33 und seine Umhüllung 38 und die beiden Modulanschlusskontakte 34 und 35 von derselben Trägerhauptfläche, nämlich der zweiten Trägerhauptfläche 32 des Trägers 30 des Moduls 29 abstehen - der Verlauf der Spulenwindungen 3 der Spule 2 und die Ausbildung der Spule 2 in der Umgebung des Chips 33 keinen einschränkenden Einflüssen durch die Anwesenheit des Chips 33 unterliegen.

Die Erfindung ist auf die vorstehend beschriebenen Ausführungsbeispiele nicht beschränkt. So können zum Herstellen eines Datenträgerkörpers und zum Anbringen einer Ausnehmung in dem Datenträgerkörper auch andere geeignete Techniken zur Anwendung kommen, beispielsweise Ätztechniken oder Lasertechniken. Auch stehen zum Herstellen der Spulen andere geeignete Techniken zur Verfügung, beispielsweise Ätztechniken. Auch können in einem Datenträgerkörper auch zwei oder mehr als zwei Spulen aufgenommen sein. Ein in einen Datenträger eingesetzter Modul muss nicht unbedingt nur einen Chip als Bauteil enthalten, sondern kann auch einen Kondensator oder einen druckempfindlichen Folienschalter und dergleichen als Bauteil aufweisen. Erwähnt sei weiters noch, dass in einer einen erfindungsgemäßen Datenträger bildenden Chipkarte gegebenenfalls nicht nur ein einziger Chip als Bauteil, sondern auch zwei oder mehrere Chips enthalten sein können. Beispielsweise können in einer Chipkarte auch zwei Module mit je einem Chip oder auch ein Modul mit zwei Chips zum Einsatz kommen. Bei den vorstehend beschriebenen Ausführungsbeispielen sind die Träger der Module im Bereich der ersten Körperhauptfläche der Kartenkörper zugänglich, wobei die erste Trägerhauptfläche und die erste Körperhauptfläche bei den Chipkarten gemäß den drei vorstehend beschriebenen Ausführungsbeispielen fluchten; es kann aber bei einer Chipkarte auch vorgesehen sein, dass die erste Trägerhauptfläche des Trägers eines Moduls von einer Abdeckschicht abgedeckt ist, wobei dann die äußere Begrenzungsfläche dieser Abdeckschicht mit der ersten Körperhauptfläche des Kartenkörpers dieser Chipkarte fluchtet.

Bei einem Datenträger mit einem in Kunststoff-Spritzgusstechnik hergestellten Datenträgerkörper und mit einer aus einem dünnen Draht bestehenden Spule können die Spulenwindungen und die Spulenanschlusskontakte in einer Ebene liegen, so dass dann die Spulenanschlusskontakte und auch die Spulenwindungen entlang ihres gesamten Bereiches bzw. Verlaufes in einem dem Drahtdurchmesser entsprechenden Windungsniveaubereich Z1 liegen, der außerhalb des Bauteilniveaubereiches Z2 liegt. Dies muss nicht unbedingt so sein, weil die Spulenwindungen in ihrem zu dem Bauteil am Modul des Datenträgers nicht benachbarten, also in einer quer zu den Trägerhauptflächen des Trägers des Moduls verlaufenden Richtung dem Bauteil nicht gegenüberliegenden Bereich gegebenenfalls auch innerhalb des Bauteilniveaubereiches Z2 liegen können, was durch entsprechende abgebogene bzw. abgewinkelte Formgebung der Spule erreichbar ist. Entscheidend ist im vorliegenden Zusammenhang, dass die Spulenanschlusskontakte und die Spulenwindungen der Spule zumindest in ihrem zu dem Bauteil benachbarten Bereich in einem außerhalb des Bauteilniveaubereiches Z2 liegenden Windungsniveau Z1 liegen.

Es ist abschließend als wesentliches Faktum noch zu erwähnen, dass bei sämtlichen im Rahmen dieser Anmeldung beschriebenen Ausführungsbeispielen von Datenträgern die den Datenträgerkörper begrenzende besagte Körperfläche, in die die Ausnehmung mündet, in die der Modul eingesetzt ist, eine von außen zugängliche Körperaußenfläche ist. Dies muss aber nicht so sein, weil bei Datenträgern gemäß den beschriebenen Ausführungsbeispielen nach dem Einbringen des Moduls auf die besagte Körperfläche auch noch eine Abdeckschicht, beispielsweise in Form einer Abdeckfolie, aufgebracht werden kann, die im Falle eines ausschließlich für einen kontaktlosen Betrieb in einem Datenträger vorgesehenen Moduls diesen Modul zur Gänze abdecken kann und die im Fall eines für einen kontaktbehafteten Betrieb in einem Datenträger vorgesehenen Moduls diesen Modul zumindest unter teilweiser Freistellung der weiteren Modulanschlusskontakte zum Zusammenwirken mit Kontaktstiften einer Schreib/Lese-Einrichtung abdecken kann, einen solchen Modul aber auch gar nicht abdecken kann, sondern nur die besagte Körperfläche. Bei einer derartigen Ausbildung ist die Körperaußenfläche des Datenträgerkörpers eines Datenträgers durch die Außenfläche der Abdeckschicht gebildet.

## Patentansprüche

1. Datenträger (45) mit einem Datenträgerkörper (14), der von einer Körperfläche (15) begrenzt ist und in den ein Modul (29) und eine gegenüber dem Modul (29) separate, Spulenwindungen (3) und mindestens zwei Spulenanschlusskontakte (4, 5) aufweisende Spule (2) aufgenommen ist, wobei der Modul (29) einen plattenförmigen Träger (30), der im wesentlichen parallel zu der besagten Körperfläche (15) verläuft und der von einer der besagten Körperfläche (15) zugewandten ersten Trägerhauptfläche (31) und von einer von der besagten Körperfläche (15) abgewandten und zu der ersten Trägerhauptfläche (31) im wesentlichen parallelen zweiten Trägerhauptfläche (32) begrenzt ist, und mindestens einen Bauteil (33), der in den Datenträgerkörper (14) aufgenommen und mit dem Träger (30) verbunden und gegenüber der zweiten Trägerhauptfläche (32) erhaben ist und der in einem sich quer zu der besagten Körperfläche (15) erstreckenden Bauteilniveaubereich (Z2) liegt, und mindestens zwei Modulanschlusskontakte (34, 35) aufweist, die mit dem Träger (30) verbunden und in dem Bereich der zweiten Trägerhauptfläche (32) vorgesehen sind, und wobei die Spulenwindungen (3) und die Spulenanschlusskontakte (4, 5) der Spule (2) zumindest in ihrem zu dem Bauteil (33) benachbarten Bereich in einem sich quer zu der besagten Körperfläche (15) erstreckenden und außerhalb des Bauteilniveaubereiches (Z2) liegenden Spulenniveaubereich (Z1) liegen und wobei jeder Spulenanschlusskontakt (4, 5) in einer quer zu der zweiten Trägerhauptfläche (32) verlaufenden Richtung einem Modulanschlusskontakt (34, 35) gegenüberliegt und mit letzterem in elektrisch leitender Verbindung steht und wobei zwischen jedem Modulanschlusskontakt (34, 35) und dem ihm gegenüberliegenden Spulenanschlusskontakt (4, 5) ein über seine gesamte Länge von dem Datenträgerkörper (14) umgebener, an die beiden Anschlusskontakte (34, 35, 4, 5) angrenzender Kanal (21, 22) vorgesehen ist und wobei jeder Kanal (21, 22) als elektrisch leitendes Verbindungsmittel (28) eine in einem pastösen oder flüssigen Zustand in den Kanal (21, 22) einbringbare elektrisch leitende Masse (28) enthält, mit dem die elektrisch leitende Verbindung zwischen einem Modulanschlusskontakt (34, 35) und einem Spulenanschlusskontakt gebildet ist, **dadurch gekennzeichnet, dass** jeder Kanal (21, 22) an seinem von dem an ihn angrenzenden Spulenanschlusskontakt (4, 5) abgewandten und dem an ihn angrenzenden Modulanschlusskontakt (34, 35) zugewandten Ende eine von dem Kanal (21, 22) seitlich weg verlaufende Tasche (23, 24) aufweist, in der überschüssige elektrisch leitende Masse (28) aufnehmbar ist.

2. Datenträger (45) nach Anspruch 1, bei dem der Datenträger (45) eine abgestufte Ausnehmung (17) aufweist, die in die besagte Körperfläche (15) mündet und die einen an die besagte Körperfläche (15) angrenzenden, im Querschnitt größeren ersten Ausnehmungsbereich (18), der durch eine im wesentlichen parallel zu der besagten Körperfläche (15) verlaufende ringförmige Begrenzungsfläche (19) begrenzt ist, und einen an den ersten Ausnehmungsbereich (18) an dessen von der besagten Körperfläche (15) abgewandter Seite anschließenden, im Querschnitt kleineren zweiten Ausnehmungsbereich (20) aufweist und in die der Modul (29) eingesetzt ist, wobei der Träger (30) des Moduls (29) mit einem ringförmigen Abschnitt (39) der zweiten Trägerhauptfläche (32) der ringförmigen Begrenzungsfläche (19) des ersten Ausnehmungsbereiches (18) gegenüberliegt, und bei dem die Modulanschlusskontakte (34, 35) zumindest teilweise im Bereich des ringförmigen Abschnittes (39) der zweiten Trägerhauptfläche (32) vorgesehen sind und bei dem die Kanäle (21, 22) von der ringförmigen Begrenzungsfläche (19) des ersten Ausnehmungsbereiches (18) ausgehend durch den Datenträgerkörper (14) hindurch bis zu den Spulenanschlusskontakten (4, 5) reichen, **dadurch gekennzeichnet, dass** die von den Kanälen (21, 22) seitlich weg verlaufenden Taschen (23, 24) ebenso von der ringförmigen Begrenzungsfläche (19) des ersten Ausnehmungsbereiches (18) ausgehen und zu dieser Begrenzungsfläche (19) hin offen sind.

3. Datenträger (45) nach Anspruch 2, **dadurch gekennzeichnet, dass** die Ausnehmung (17) und die Kanäle (21, 22) und die Taschen (23, 24) durch einen Fräsvorgang hergestellt sind.

4. Datenträger (45) nach einem der Ansprüche 1 bis 3, **dadurch gekennzeichnet, dass** jeder Kanal (21, 22) als elektrisch leitende Masse (28), die das elektrisch leitende Verbindungsmittel (28) bildet, ein elektrisch leitendes Klebemittel enthält.

5. Datenträger (45) nach einem der Ansprüche 1 bis 4, **dadurch gekennzeichnet, dass** die Spulenwindungen (3) und die Spulenanschlusskontakte (4, 5) der Spule (2) durch mit einem Siebdruckverfahren hergestellte Leiterbahnen gebildet sind.

6. Datenträger (45) nach Anspruch 5, **dadurch gekennzeichnet, dass** die Spulenwindungen (3) und die Spulenanschlusskontakte (4, 5) der Spule (2) durch mit einem Siebdruckverfahren unter Verwendung einer Silberleitpaste hergestellte Leiterbahnen gebildet sind.

7. Datenträger (45) nach einem der Ansprüche 1 bis 6, **dadurch gekennzeichnet, dass** mit dem Träger (30) des Moduls (29) im Bereich seiner ersten Trägerhauptfläche (31) vorgesehene weitere Modulanschlusskontakte (46, 47) verbunden sind, die zum Zusammenwirken mit von außerhalb des Datenträgers (45) mit ihnen in Kontaktverbindung bringbaren Gegenkontakten ausgebildet sind.

8. Datenträger (45) nach einem der Ansprüche 1 bis 7, **dadurch gekennzeichnet, dass** der Datenträger (45) als Chipkarte ausgebildet ist.

9. Verfahren zum Herstellen eines Datenträgers (45), bei dem ein Datenträgerkörper (14) hergestellt wird, der von einer Körperfläche (15) begrenzt ist, und bei dem beim Herstellen des Datenträgerkörpers (14) eine Spule (2), die Spulenwindungen (3) und mindestens zwei Spulenanschlusskontakte (4, 5) aufweist, in den Datenträgerkörper (14) aufgenommen wird, wobei die Spulenwindungen (3) und die Spulenanschlusskontakte (4, 5) zumindest in ihrem zu einem Bauteil (33) benachbarten Bereich in einem sich quer zu der besagten Körperfläche (15) erstreckenden und außerhalb eines Bauteilniveaubereiches (Z2) liegenden Spulenniveaubereich (Z1) zu liegen kommen, und bei dem in den Datenträgerkörper (14) ein Modul (29) aufgenommen wird, der einen plattenförmigen, von einer ersten Trägerhauptfläche (31) und von einer zu der ersten Trägerhauptfläche (31) im wesentlichen parallelen zweiten Trägerhauptfläche (32) begrenzten Träger (30) und einen mit dem Träger (30) verbundenen, gegenüber der zweiten Trägerhauptfläche (32) erhabenen Bauteil (33) und mindestens zwei mit dem Träger (30) verbundene, im Bereich der zweiten Trägerhauptfläche (32) vorgesehene Modulanschlusskontakte (34, 35) aufweist, wobei die erste Trägerhauptfläche (31) der besagten Körperfläche (15) zugewandt und die zweite Trägerhauptfläche (32) von der besagten Körperfläche (15) abgewandt zu liegen kommen und wobei der Bauteil (33) in dem sich quer zu der besagten Körperfläche (15) erstreckenden Bauteilniveaubereich (Z2) zu liegen kommt, und bei dem je ein Modulanschlusskontakt (34, 35) und je ein Spulenanschlusskontakt (4, 5) in einer quer zu der zweiten Trägerhauptfläche (32) verlaufenden Richtung einander gegenüberliegend zu liegen kommen und in elektrisch leitende Verbindung gebracht werden und bei dem in dem Datenträgerkörper (14) quer zu der besagten Körperfläche (15) verlaufende, über ihre gesamte Länge von dem Datenträgerkörper (14) umgebene Kanäle (21, 22) hergestellt werden, von denen jeder bis zu einem Spulenanschlusskontakt (4, 5) reicht und von denen jeder vor dem Aufnehmen des Moduls (29) in den Datenträgerkörper (14) über sein von dem Spulenanschlusskontakt (4, 5) abgewandtes Ende von außen her zugänglich ist, und bei dem in jeden Kanal (21, 22) als elektrisch leitendes Verbindungsmittel (28) eine pastöse oder flüssige elektrisch leitende Masse (28) eingebracht wird und bei dem beim Aufnehmen des Moduls (29) in den Datenträgerkörper (14) jeder mit dem Träger (30) des Moduls (29) verbundene Modulanschlusskontakt (34, 35) mit der in einen Kanal (21, 22) eingebrachten elektrisch leitenden Masse (28) mit einem gegenüberliegenden Spulenanschlusskontakt (4, 5) in elektrisch leitende Verbindung gebracht wird, **dadurch gekennzeichnet, dass** die Kanäle (21, 22) mit einem Materialabtragungsverfahren hergestellt werden und dass jeder Kanal (21,22) an seinem von dem an ihn angrenzenden Spulenanschlusskontakt (4, 5) abgewandten Ende mit einer von dem Kanal (21, 22) seitlich weg verlaufenden Tasche (24, 25) versehen wird, in der überschüssige elektrisch leitende Masse (28) aufnehmbar ist.

10. Verfahren nach Anspruch 9, bei dem in dem Datenträgerkörper (14) eine abgestufte Ausnehmung (17) hergestellt wird, die in die besagte Körperfläche (15) mündet und die einen an die besagte Körperfläche (15) angrenzenden, im Querschnitt größeren ersten Ausnehmungsbereich (18), der durch eine im wesentlichen parallel zu der besagten Körperfläche (15) verlaufende ringförmige Begrenzungsfläche (19) begrenzt ist, und einen an den ersten Ausnehmungsbereich (18) an dessen von der besagten Körperfläche (15) abgewandter Seite anschließenden, im Querschnitt kleineren zweiten Ausnehmungsbereich (20) aufweist, und bei dem in dem Datenträgerkörper (14) Kanäle (21, 22) hergestellt werden, von denen jeder von der ringförmigen Begrenzungsfläche (19) des ersten Ausnehmungsbereiches (18) ausgehend durch den Datenträgerkörper (14) hindurch bis zu einem Spulenanschlusskontakt (4, 5) reicht, **dadurch gekennzeichnet, dass** in dem hergestellten Datenträgerkörper (14) mit einem Materialabtragungsverfahren die abgestufte Ausnehmung (17) hergestellt wird und dass in dem hergestellten Datenträgerkörper (14) mit einem, vorzugsweise mit demselben Materialabtragungsverfahren die Kanäle (21, 22) und ebenso die von den Kanälen (21, 22) seitlich weg verlaufenden Taschen (23, 24) hergestellt werden, von denen jede ebenso von der ringförmigen Begrenzungsfläche (19) des ersten Ausnehmungsbereichs (18) ausgeht und zu dieser Begrenzungsfläche (19) hin offen ist, und dass der Modul (29) mit dem Bauteil (33) und den Modulanschlusskontakten (34, 35) voran in die Ausnehmung (17) eingesetzt wird, wobei jeder mit dem Träger (30) des Moduls (29) verbundene Modulanschlusskontakt (34, 35) mit der in einen Kanal (21, 22) eingebrachten elektrisch leitenden Masse (28) mit einem gegenüberliegenden Spulenanschlusskontakt (4, 5) in elektrisch leitende Verbindung gebracht wird und gegebenenfalls überschüssige elektrisch leitende Masse (28) in die von einem Kanal (21, 22) seitlich weg verlaufende Tasche (23, 24) gedrückt wird.

11. Verfahren nach Anspruch 10, **dadurch gekennzeichnet, dass** die Materialabtragung zum Herstellen der Ausnehmung (17) und der Kanäle (21, 22) sowie der Taschen (23, 24) durch einen Fräsvorgang erfolgt.

12. Verfahren nach einem der Ansprüche 9 bis 11, **dadurch gekennzeichnet, dass** in jeden Kanal (21, 22) als elektrisch leitende Masse (28), die das elektrisch leitende Verbindungsmittel bildet, ein elektrisch leitendes Klebemittel eingebracht wird.

13. Verfahren nach einem der Ansprüche 9 bis 12, **dadurch gekennzeichnet, dass** vor dem Einbringen der elektrisch leitenden Masse (28) in die Kanäle (21, 22) und vor dem Einsetzen des Moduls (29) in die Ausnehmung (17) durch die Kanäle (21, 22) hindurch mit den Spulenanschlusskontakten (4, 5) eine Prüfeinrichtung zum Prüfen der einwandfreien Funktionstüchtigkeit der Spule (2) in Wirkverbindung gebracht wird.

14. Verfahren nach einem der Ansprüche 9 bis 13, **dadurch gekennzeichnet, dass** vor dem Einsetzen des Moduls (29) in die Ausnehmung (17) in einem Randbereich (39) der zweiten Trägerhauptfläche (32) des Trägers (30) des Moduls (29) ein Heißschmelz-Klebemittel (40) aufgetragen wird und dass nach dem Einsetzen des Moduls (29) in die Ausnehmung (17) auf die erste Trägerhauptfläche (31) des Trägers (30) des Moduls (29) ein Heizstempel (43) einer Heizvorrichtung zum Aktivieren des Heißschmelz-Klebemittels (40) aufgesetzt wird.

15. Verfahren nach einem der Ansprüche 9 bis 14, **dadurch gekennzeichnet, dass** die Spulenwindungen (3) und die Spulenanschlusskontakte (4, 5) der Spule (2) auf eine Trägerfolie (1) aufgebracht werden und dass danach die Trägerfolie (1) mit den auf ihr aufgebrachten Spulenwindungen (3) und Spulenanschlusskontakten (4, 5) der Spule (2) mit mindestens einer weiteren Folie (8, 9, 10, 11, 12) gestapelt wird, wobei die Spulenwindungen (3) und die Spulenanschlusskontakte (4, 5) der Spule (2) zwischen der Trägerfolie (1) und einer Deckfolie (11) zu liegen kommen, und dass danach die gestapelten Folien (1, 8, 9, 10, 11, 12) durch einen Laminiervorgang zum Herstellen des Datenträgerkörpers (14) laminiert werden.

16. Verfahren nach Anspruch 15, **dadurch gekennzeichnet, dass** als Trägerfolie (1), auf die die Spulenwindungen (3) und die Spulenanschlusskontakte (4, 5) der Spule (2) aufgebracht werden, eine aus Polycarbonat bestehende Folie verwendet wird.

17. Verfahren nach Anspruch 16, **dadurch gekennzeichnet, dass** als Deckfolie (11), die beim Stapeln der Folien (1, 8, 9, 10, 11, 12) den Spulenwindungen (3) und den Spulenanschlusskontakten (4, 5) der Spule (2) unmittelbar gegenüberliegt; eine aus Polyvinylchlorid bestehende Folie verwendet wird.

18. Verfahren nach einem der Ansprüche 15 bis 17, **dadurch gekennzeichnet, dass** die Spulenwindungen (3) und die Spulenanschlusskontakte (4, 5) der Spule (2) durch Aufbringen eines leitfähigen Materials auf die Trägerfolie (1) in einem Siebdruckvorgang hergestellt werden.

19. Verfahren nach Anspruch 18, **dadurch gekennzeichnet, dass** die Spulenwindungen (3) und die Spulenanschlusskontakte (4, 5) der Spule (2) durch Aufbringen einer Silberleitpaste auf die Trägerfolie (1) in einem Siebdruckvorgang hergestellt werden.

## Claims

1. A data carrier (45) comprising a data carrier body (14) bounded by a body surface (15) and incorporating a module (29) and a coil (2), which coil is separate from the module (29) and has coil turns (3) and at least two coil-connecting contacts (4, 5), the module (29) comprising a plate-shaped carrier (30), which extends substantially parallel to said body surface (15) and is bounded by a first carrier main surface (31) facing said body surface (15) and by a second carrier main surface (32) remote from said body surface (15) and being substantially parallel to the first carrier main surface (31), and at least one component (33), which component is incorporated in the data carrier body (14), is connected to the carrier (30), is raised with respect to the second carrier main surface (32), and is disposed in a component level zone (Z2) which extends transversely to said body surface (15), and at least two module-connecting contacts (34, 35) connected to the carrier (30) and arranged in the area of the second carrier main surface (32), and in which the coil turns (3) and the coil-connecting contacts (4, 5) of the coil (2) are disposed, at least in their area adjacent the component (33), in a coil level zone (Z1) extending transversely to said body surface (15) and being situated outside the component level zone (Z2), and each coil-connecting contact (4, 5) is disposed opposite a module-connecting contact (34, 35) in a direction transverse to the second carrier main surface (32) and connected to the last-mentioned connecting contact in an electrically conductive manner, and a channel (21, 22) surrounded throughout its length by the data carrier body (14) and adjoining the two connecting contacts (34, 35, 4, 5) is provided between each module-connecting contact (34, 35) and its facing coil-connecting contact (4, 5), and each channel (21, 22) contains an electrically conductive substance (28) as the electrically conductive connecting means (28) which can be introduced into the channel (21, 22) in a pasty or liquid condition, which forms the electrically conductive connection between a module-connecting contact (34, 35) and a coil-connecting contact, **characterized in that** each channel (21, 22), at its end remote from its adjacent coil-connecting contact (4, 5) and facing its adjacent module-connecting contact (34, 35), is provided with a pocket (23, 24) which extends in a lateral direction away from the channel (21, 22) and is adapted to receive a surplus of electrically conductive substance (28).

2. A data carrier (45) as claimed in claim 1, in which the data carrier (45) has a stepped recess (17) which terminates in said body surface (15) and has a cross-sectionally larger first recess portion (18), which adjoins said body surface (15) and is bounded by an annular bounding surface (19) substantially parallel to said body surface (15), and a cross-sectionally smaller second recess portion (20), which adjoins the first recess portion (18) at the side which is remote from said body surface (15) and which accommodates the module (29), an annular portion (39) of the second carrier main surface (32) of the carrier (30) of the module (29) facing the annular bounding surface (19) of the first recess portion (18), and the module-connecting contacts (34, 35) are disposed at least partly in the area of the annular portion (39) of the second carrier main surface (32), and the channels (21, 22) extend from the annular bounding surface (19) of the first recess portion (18) up to the coil-connecting contacts (4, 5) through the data carrier body (14), **characterized in that** the pockets (23, 24) extending laterally from the channels (21, 22) also extend from the annular bounding surface (19) of the first recess portion (18) and are open towards this bounding surface (19).

3. A data carrier (45) as claimed in claim 2, **characterized in that** the recess (17) and the channels (21, 22) and the pockets (23, 24) have been formed by means of a milling operation.

4. A data carrier (45) as claimed in any one of claims 1 to 3, **characterized in that** each channel (21, 22) contains an electrically conductive adhesive as the electrically conductive substance (28) constituting the electrically conductive connecting means (28).

5. A data carrier (45) as claimed in any one of claims 1 to 4, **characterized in that** the coil turns (3) and the coil-connecting contacts (4, 5) of the coil (2) are constituted by conductor tracks formed by means of a screen-printing process.

6. A data carrier (45) as claimed in claim 5, **characterized in that** the coil turns (3) and the coil-connecting contacts (4, 5) of the coil (2) are constituted by conductor tracks formed by means of a screen-printing process using a conductive silver paste.

7. A data carrier (45) as claimed in any one of claims 1 to 6, **characterized in that** further module-connecting contacts (46, 47) arranged in the area of the first carrier main surface (31) are connected to the carrier (30) of the module (29) and are adapted to cooperate with mating contacts with which they are engageable from outside the data carrier (45).

8. A data carrier (45) as claimed in any one of claims 1 to 7, **characterized in that** the data carrier (45) is constructed as a chip card.

9. A method of manufacturing a data carrier (45), in which a data carrier body (14) is manufactured, which data carrier body is bounded by a body surface (15) and in which during the manufacture of the data carrier body (14) a coil (2) having coil turns (3) and at least two coil-connecting contacts (4, 5) is incorporated in the data carrier body (14), which coil turns (3) and coil-connecting contacts (4, 5) are then disposed, at least in their area adjacent the component (33), in a coil level zone (Z1) extending transversely to said body surface (15) and being situated outside a component level zone (Z2), and in which a module (29) is incorporated in the data carrier body (14), which module comprises a plate-shaped carrier (30), which is bounded by a first carrier main surface (31) and by a second carrier main surface (32) substantially parallel to the first carrier main surface (31), and a component (33), which is connected to the carrier (30) and is raised with respect to the second carrier main surface (32), and at least two module-connecting contacts (34, 35) connected to the carrier (30) and arranged in the area of the second carrier main surface (32), the first carrier main surface (31) then facing said body surface (15) and the second carrier main surface (32) then being remote from said body surface (15) and the component (33) then being disposed in a component level zone (Z2) which extends transversely to said body surface (15), and each module-connecting contact (34, 35) and each coil-connecting contact (4, 5) then being disposed opposite one another in a direction transverse to the second carrier main surface (32) and being connected in an electrically conductive manner, and in which channels (21, 22) extending transversely to said body surface (15) and being surrounded throughout their length by the data carrier body (14) are made in the data carrier body (14), each of which channels extends up to a coil-connecting contact (4, 5) and, prior to the placement of the module (29) in the data carrier body (14), is accessible from the exterior via its end which is remote from the coil-connecting contact (4, 5), and in which a pasty or liquid electrically conductive substance (28) is introduced as the electrically conductive connecting means (28) into each channel (21, 22), and, when the module (29) is placed in the data carrier body (14), each module-connecting contact (34, 35) connected to the carrier (30) of the module (29) is connected to a facing coil-connecting contact (4, 5) in an electrically conductive manner by the electrically conductive substance (28) introduced into a channel (21, 22), **characterized in that** the channels (21, 22) are formed by means of a material removal method, and **in that** the end of each channel (21, 22) remote from its adjoining coil-connecting contact (4, 5) is provided with a pocket (24, 25) extending laterally from the channel (21, 22), which pocket is adapted to receive surplus electrically conductive substance (28).

10. A method as claimed in claim 9, in which a stepped recess (17) is made in the data carrier body (14), which recess terminates in said body surface (15) and has a cross-sectionally larger first recess portion (18), which adjoins said body surface (15) and is bounded by an annular bounding surface (19) substantially parallel to said body surface (15), and a cross-sectionally smaller second recess portion (20), which adjoins the first recess portion (18) at the side which is remote from said body surface (15), and in which channels (21, 22) are formed in the data carrier body (14), which channels each extend from the annular bounding surface (19) of the first recess portion (18) to a coil-connecting contact (4, 5) through the data carrier body (14), **characterized in that**, in the manufactured data carrier body (14), the stepped recess (17) is formed by means of a material removal method and **in that**, in the manufactured data carrier body (14), the channels (21, 22) as well as the pockets (23, 24) extending laterally from the channels (21, 22) are formed preferably by means of the same material removal method, which channels each also extend from the annular bounding surface (19) of the first recess portion (18) and are open towards this bounding surface (19), and **in that** the module (29) is placed in the recess (17) with the component (33) and the module-connecting contacts (34, 35) facing forward, each module-connecting contact (34, 35) connected to the carrier (30) of the module (29) being connected to a facing coil-connecting contact (4, 5) in an electrically conductive manner by the electrically conductive substance (28) introduced into a channel (21, 22), and a surplus, if any, of electrically conductive substance (28) being urged into the pocket (23, 24) extending laterally from a channel (21, 22).

11. A method as claimed in claim 10, **characterized in that** the material removal for the formation of the recess (17) and the channels (21, 22) as well as the pockets (23, 24) is effected by means of a milling operation.

12. A method as claimed in any one of claims 9 to 11, **characterized in that** an electrically conductive adhesive is introduced into each channel (21, 22) as an electrically conductive substance (28) constituting the electrically conductive connecting means.

13. A method as claimed in any one of claims 9 to 12, **characterized in that** a test device for testing whether the coil (2) is in good working order is operationally connected to the coil-connecting contacts (4, 5) via the channels (21, 22) before the electrically conductive substance (28) is introduced into the channels (21, 22) and before the module (29) is placed in the recess (17).

14. A method as claimed in any one of claims 9 to 13, **characterized in that**, before the module (29) is placed in the recess (17), a hot-melt adhesive (40) is applied in a peripheral area (39) of the second carrier main surface (32) of the carrier (30) of the module (29) and **in that**, after the module (29) has been placed in the recess (17), a heating die (43) of a heating device for activating the hot-melt adhesive (40) is placed onto the first carrier main surface (31) of the carrier (3 0) of the module (29).

15. A method as claimed in any one of claims 9 to 14, **characterized in that** the coil turns (3) and the coil-connecting contacts (4, 5) of the coil (2) are formed on a carrier foil (1) and subsequently the carrier foil (1), with the coil turns (3) and the coil-connecting contacts (4, 5) of the coil (2) formed on it, is stacked with at least one further foil (8, 9, 10, 11, 12), the coil turns (3) and the coil-connecting contacts (4, 5) of the coil (2) then being interposed between the carrier foil (1) and a cover foil (11), and **in that** subsequently the stacked foils (1, 8, 9, 10, 11, 12) are laminated by means of a lamination process in order to form the data carrier body (14).

16. A method as claimed in claim 15, **characterized in that** a polycarbonate foil is used as the carrier foil (1) on which the coil turns (3) and the coil-connecting contacts (4, 5) of the coil (2) are formed.

17. A method as claimed in claim 16, **characterized in that** a polyvinyl chloride foil is used as the cover foil (11) which directly adjoins the coil turns (3) and the coil-connecting contacts (4, 5) of the coil (2) during stacking of the foils (1, 8, 9, 10, 11, 12).

18. A method as claimed in any one of claims 15 to 17, **characterized in that** the coil turns (3) and the coil-connecting contacts (4, 5) of the coil (2) are formed by depositing a conductive material on the carrier foil (1) in a screen-printing process.

19. A method as claimed in claim 18, **characterized in that** the coil turns (3) and the coil-connecting contacts (4, 5) of the coil (2) are formed by depositing a conductive silver paste on the carrier foil (1) in a screen-printing process.

## Revendications

1. Support de données (45) avec un corps de support de données (14) qui est délimité par une surface de corps (15) et dans lequel sont insérés un module (29) et une bobine (2), séparée par rapport au module (29), présentant des enroulements de bobine (3) et au moins deux contacts de connexion de bobine (4, 5), le module (29) présentant un support (30) en forme de plaque qui est essentiellement parallèle à ladite surface de corps (15) et qui est délimité par une première surface principale de support (31) tournée vers l'une desdites surfaces de corps (15) et une deuxième surface principale de support (32) essentiellement parallèle à la première surface principale de support (31) et opposée à ladite surface de corps (15) et au moins un composant (33) qui est inséré dans le corps de support de données (14) et est relié avec le support (30) et est relevé par rapport à la deuxième surface principale de support (32) et qui se trouve dans une zone du niveau des composants (Z2) s'étendant perpendiculairement à ladite surface de corps (15) et au moins deux contacts de connexion de module (34, 35) qui sont reliés avec le support (30) et sont prévus dans la région de la deuxième surface principale de support (32) et dans lequel les enroulements de bobine (3) et les contacts de connexion de bobine (4, 5) de la bobine (2) se trouvent au moins dans sa région proche du composant (33) dans une zone de niveau de bobine (Z1) se situant à l'extérieur de la zone du niveau des composants (Z2) et s'étendant perpendiculairement par rapport à ladite surface de corps (15) et dans lequel chaque contact de connexion de bobine (4, 5) est opposé à un contact de connexion de module (34, 35) s'étendant perpendiculairement à la deuxième surface principale de support (32) et se trouve en liaison conductrice électriquement avec ce dernier et dans lequel il est prévu, entre chaque contact de connexion de module (34, 35) et le contact de connexion de bobine (4, 5) opposé à celui-ci, un canal (21, 22) adjacent aux deux contacts de connexion (34, 35, 4, 5) et entouré sur toute sa longueur du corps de support de données (14) et dans lequel chaque canal (21, 22) contient comme moyen de connexion (28) électriquement conducteur une masse électriquement conductrice (28) à introduire dans le canal (21, 22) à l'état pâteux ou liquide, avec laquelle la connexion électriquement conductrice est formée entre un contact de connexion de module (34, 35) et un contact de connexion de bobine (34, 35), **caractérisé en ce que** chaque canal (21, 22) présente une poche (23, 24) s'écartant latéralement du canal (21, 22) dans laquelle la masse électriquement conductrice (28) excédentaire peut être recueillie sur son extrémité opposée au contact de connexion de bobine (4, 5) adjacent à celui-ci et sur son extrémité tournée vers le contact de connexion de module (34, 35) adjacent à celui-ci.

2. Support de données (45) selon la revendication 1, dans lequel le support de données (45) présente un évidement (17) étagé qui débouche dans ladite surface de corps (15) et présente une première zone d'évidement (18) de section plus grande et adjacente à ladite surface de corps (15) qui est délimitée par une surface de délimitation (19) circulaire s'étendant essentiellement parallèlement à ladite surface de corps (15) et une deuxième zone d'évidement (20) de section plus petite qui fait suite à la première zone d'évidement (18) sur sa face opposée à ladite surface de corps (15) et dans laquelle le module (29) est inséré, le support (30) du module (29) avec une section circulaire (39) de la deuxième surface principale de support (32) faisant face à la surface de délimitation (19) circulaire de la première zone d'évidement (18) et dans lequel les contacts de connexion de module (34, 35) sont prévus, du moins en partie, dans la région de la section circulaire (39) de la deuxième surface principale de support (32) et dans lequel les canaux (21, 22) s'étendent en partant de la surface de délimitation (19) circulaire de la première zone d'évidement (18) au travers du corps de support de données (14) et jusqu'aux contacts de connexion de bobine (4, 5) **caractérisé en ce que** les poches (23, 24) s'écartent latéralement des canaux (21, 22), tout comme la surface de délimitation (19) circulaire de la première zone d'évidement (18) et sont ouvertes vers cette surface de délimitation (19).

3. Support de données (45) selon la revendication 2, **caractérisé en ce que** l'évidement (17) et les canaux (21, 22) et les poches (23, 24) sont fabriqués par une procédure de fraisage.

4. Support de données (45) selon l'une des revendications 1 à 3, **caractérisé en ce que** chaque canal (21, 22) contient un adhésif électriquement conducteur comme masse (28) électriquement conductrice qui forme le moyen de connexion (28) électriquement conducteur.

5. Support de données (45) selon l'une des revendications 1 à 4, **caractérisé en ce que** les enroulements de bobine (3) et les contacts de connexion de bobine (4, 5) de la bobine (2) sont formés par des pistes conductrices fabriquées avec un procédé de sérigraphie.

6. Support de données (45) selon la revendication 5, **caractérisé en ce que** les enroulements de bobine (3) et les contacts de connexion de bobine (4, 5) de la bobine (2) sont formés des par pistes conductrices fabriquées avec un procédé de sérigraphie en utilisant une pâte conductrice en argent.

7. Support de données (45) selon l'une des revendications 1 à 6, **caractérisé en ce qu'**on relie au support (30) du module (29) des contacts de connexion de module (46, 47) supplémentaires, prévus dans la région de sa première surface principale de support (31), qui sont conçus pour coopérer avec des contre-contacts à mettre en relation par contact avec eux en dehors du support de données (45).

8. Support de données (45) selon l'une des revendications 1 à 7, **caractérisé en ce que** le support de données (45) est conçu comme une carte à puce.

9. Procédé de fabrication d'un support de données (45) au cours duquel un corps de support de données (14) qui est limité par une surface de corps (15) est confectionné et au cours duquel, pour la confection du corps de support de données (14), une bobine (2) qui contient des enroulements de bobine (3) et au moins deux contacts de connexion de bobine (4, 5), est incluse dans le corps de support de données (14), dans lequel les enroulements de bobine (3) et les contacts de connexion de bobine (4, 5) viennent se placer, du moins dans leur zone voisine à un composant (33), dans une zone de niveau de bobine (Z1) s'étendant perpendiculairement à ladite surface de corps (15) et située à l'extérieur de la zone du niveau des composants (Z2) et dans lequel on inclut dans le corps de support de données (14) un module (29) qui présente un support (30) en forme de plaque délimité par une première surface principale de support (31) et par une deuxième surface principale de support (32) essentiellement parallèle à la première surface principale de support (31) et un composant (33) relié au support (30) et relevé par rapport à la deuxième surface principale de support (32) et au moins deux contacts de connexion de module (34, 35) reliés au support (30) et prévus dans la région de la deuxième surface principale de support (32), la première surface principale de support (31) étant tournée vers ladite surface de corps (15) et la deuxième surface principale de support (32) étant opposée à ladite surface de corps (15) et dans lequel le composant (33) vient se placer dans une zone de niveau des composants (Z2) s'étendant perpendiculairement à ladite surface de corps (15) et dans lequel un contact de connexion de module (34, 34) et un contact de connexion de bobine (4, 5) viennent respectivement se placer en vis-à-vis dans une direction s'étendant perpendiculairement à la deuxième surface principale de support (32) et sont mis en liaison de manière électriquement conductrice et dans lequel sont confectionnés des canaux (21, 22) entourés par le corps de support de données (14) sur toute sa longueur et s'étendant dans le corps de support de données (14) perpendiculairement à ladite surface de corps (15), chacun d'eux allant jusqu'à un contact de connexion de bobine (4, 5) et étant accessible de l'extérieur avant l'introduction du module (29) dans le corps de support de données (14) par l'intermédiaire de son extrémité opposée au contact de connexion de bobine (4, 5), dans lequel une masse électriquement conductrice (28) pâteuse ou liquide est introduite dans chaque canal (21, 22) comme moyen de liaison électriquement conducteur (28) et dans lequel, lors de l'introduction du module (29) dans le corps du support de données (14), chaque contact de connexion de module 34, 35) relié au support (30) du module (29) est mis en liaison électriquement conductrice avec la masse (28) électriquement conductrice introduite dans un canal (21, 22) avec un contact de connexion de bobine (4, 5) opposé, **caractérisé en ce que** les canaux (21, 22) sont fabriqués par un procédé d'enlèvement de matière et que chaque canal (21, 22) est doté à son extrémité opposée au contact de connexion de bobine (4, 5) adjacent à celui-ci avec une poche (24, 25) s'écartant latéralement du canal (21, 22) dans laquelle la masse (28) électriquement conductrice excédentaire peut être recueillie.

10. Procédé selon la revendication 9, dans lequel on ménage dans le corps de support de données (14) un évidement (17) étagé qui débouche dans ladite surface de corps (15) et présente une première zone d'évidement (18) de section plus grande et adjacente à ladite surface de corps (15) qui est délimitée par une surface de délimitation (19) circulaire s'étendant essentiellement parallèlement à ladite surface de corps (15) et une deuxième zone d'évidement (20) de section plus petite qui fait suite à la première zone d'évidement (18) sur sa face opposée à ladite surface de corps (15) et dans laquelle le module (29) est inséré, le support (30) du module (29) avec une section circulaire (39) de la deuxième surface principale de support (32) faisant face à la surface de délimitation (19) circulaire de la première zone d'évidement (18) et dans lequel les contacts de connexion de module (34, 35) sont prévus, du moins en partie, dans la région de la section circulaire (39) de la deuxième surface principale de support (32) et dans lequel les canaux (21, 22) s'étendent en partant de la surface de délimitation (19) circulaire de la première zone d'évidement (18) au travers du corps de support de données (14) et jusqu'aux contacts de connexion de bobine (4, 5), **caractérisé en ce que**, dans le corps de support de données (14) fabriqué, on fabrique l'évidement (17) étagé avec un procédé d'enlèvement de matière et que, dans le corps de support de données (14) fabriqué, on fabrique avec un procédé d'enlèvement de matière, de préférence avec le même, les canaux (21, 22), tout comme les poches (23, 24) s'écartant latéralement des canaux (21, 22), dont chacune part de la surface de délimitation (19) circulaire de la première zone d'évidement (18) et est ouverte vers cette surface de délimitation (19) et que le module (29) est inséré avec le composant (33) et les contacts de connexion de module (34, 35) par l'avant dans l'évidement (17), chaque contact de connexion de module (34, 35) relié au support (30) du module (29) étant mis en liaison électriquement conductrice avec la masse (28) électriquement conductrice introduite dans un canal (21, 22) avec un contact de connexion de bobine (4, 5) opposé et la masse (28) électriquement conductrice éventuellement excédentaire est expulsée dans la poche (23, 24) s'écartant latéralement d'un canal (21, 22).

11. Procédé selon la revendication 10, **caractérisé en ce que** l'enlèvement de matière est effectué pour la fabrication de l'évidement (17) et des canaux (21, 22) ainsi que des poches (23, 24) par une procédure de fraisage.

12. Procédé selon l'une des revendications 9 à 11, **caractérisé en ce que**, dans chaque canal (21, 22), un adhésif électriquement conducteur est introduit comme masse (28) électriquement conductrice qui forme le moyen de liaison électriquement conducteur.

13. Procédé selon l'une des revendications 9 à 12, **caractérisé en ce qu'**avant l'introduction de la masse électriquement conductrice (28) dans les canaux (21, 22) et avant l'introduction du module (29) dans l'évidement (17) par les canaux (21, 22), un dispositif de contrôle pour le contrôle de la fonctionnalité impeccable de la bobine (2) est mis en relation opérationnelle avec les contacts de connexion de bobine (4, 5).

14. Procédé selon l'une des revendications 9 à 13, **caractérisé en ce qu'**avant l'introduction du module (29) dans l'évidement (17), on applique un adhésif à fusion à chaud (40) dans une zone de bordure (39) de la deuxième surface principale de support (32) du support (30) du module (29) et qu'après l'introduction du module (29) dans l'évidement (17) un poinçon chauffant (43) d'un dispositif de chauffage est appliqué sur la première surface principale de support (31) du support (30) du module (29) pour l'activation de l'adhésif à fusion à chaud (40).

15. Procédé selon l'une des revendications 9 à 14, **caractérisé en ce que** les enroulements de bobine (3) et les contacts de connexion de bobine (4, 5) de la bobine (2) sont appliqués sur une feuille de support (1) et qu'ensuite, la feuille de support (1), avec les enroulements de bobine (3) appliqués sur celle-ci et les contacts de connexion de bobine (4, 5) de la bobine (2) est empilée avec au moins une feuille supplémentaire (8, 9, 10, 11, 12), les enroulements de bobine (3) et les contacts de connexion de bobine (4, 5) de la bobine (2) venant se placer entre la feuille de support (1) et une feuille de couverture (11) et qu'ensuite, les feuilles empilées (1, 8, 9, 10, 11, 12) sont laminées par une procédure de laminage pour la fabrication du corps de support de données (14).

16. Procédé selon la revendication 15, **caractérisé en ce qu'**une feuille composée de polycarbonate est utilisée comme feuille de support (1) sur laquelle les enroulements de bobine (3) et les contacts de connexion de bobine (4, 5) de la bobine (2) sont appliqués.

17. Procédé selon la revendication 16, **caractérisé en ce qu'**une feuille composée de chlorure de polyvinyle est utilisée comme feuille de couverture (11) qui fait face directement aux enroulements de bobine (3) et aux contacts de connexion de bobine (4, 5), de la bobine (2) lors de l'empilage des feuilles (1, 8, 9, 10, 11, 12).

18. Procédé selon l'une des revendications 15 à 17, **caractérisé en ce que** les enroulements de bobine (3) et les contacts de connexion de bobine (4, 5) de la bobine (2) sont fabriqués par application d'une matière conductrice sur la feuille de support (1) dans une procédure de sérigraphie.

19. Procédé selon la revendication 18, **caractérisé en ce que** les enroulements de bobine (3) et les contacts de connexion de bobine (4, 5) de la bobine (2) sont fabriqués par application d'une pâte conductrice en argent sur la feuille de support (1) dans une procédure de sérigraphie.
